# EUROPEAN PATENT SPECIFICATION

(11) **EP 1 341 304 B1**
(45) Date of publication and mention of the grant of the patent: **11.04.2018**
(21) Application number: 03290480.7
(22) Date of filing: 28.02.2003
(51) Int. Cl.: H03H 9/64, H03H 9/00, H03H 9/145

(54) **Surface acoustic wave filter**
Akustischer Oberflächenwellenfilter
Filtre à ondes acoustiques de surface

(30) Priority: 28.02.2002 JP 2002054781; 30.09.2002 JP 2002286320
(43) Date of publication of application: 03.09.2003
(73) Proprietor: MURATA MANUFACTURING CO., LTD., Nagaokakyo-shi, Kyoto 617-8555 (JP)
(72) Inventor: Takamine, Yuichi, Murata Manufacturing Co., Ltd., Nagaokakyo-shi, Kyoto-fu 617-8555 (JP)
(74) Representative: Delumeau, François Guy

(56) References cited:
- EP-A1- 0 633 659
- EP-A2- 1 168 614
- WO-A1-02/09279
- WO-A1-99/44285
- JP-A- 9 036 695
- JP-A- H06 177 703
- US-B2- 6 670 868
- IVANOV P G ET AL: "Wideband low loss SAW filters for telecommunication and mobile radio applications" ULTRASONICS SYMPOSIUM, 1996. PROCEEDINGS., 1996 IEEE SAN ANTONIO, TX, USA 3-6 NOV. 1996, IEEE, NEW YORK, NY, USA, vol. 1, 3 November 1996 (1996-11-03), pages 61-64, XP010217827 ISBN: 978-0-7803-3615-5
- NORITA T ET AL: "WIDEBAND LOW LOSS DOUBLE MODE SAW FILTERS" ULTRASONICS SYMPOSIUM. PROCEEDINGS, IEEE, NEW YORK, NY, US, vol. 1, 20 October 1992 (1992-10-20), pages 95-104, XP000670410 ISSN: 0090-5607
- Colin K Campbell: "Understanding Surface Acoustic Wave (SAW) Devices for Mobile and Wireless Applications and Design Techniques -- Session 19: "An Overview of SAW Devices For Mobile/Wireless Communications"", , 1 January 2008 (2008-01-01), pages 1-43, XP055099590, Internet Retrieved from the Internet: URL:http://www3.sympatico.ca/colin.kydd.ca mpbell/ [retrieved on 2014-01-31]

## Description

### BACKGROUND OF THE INVENTION

### 1. Field of the Invention

The present invention relates to a surface acoustic wave filter and, more particularly, to a surface acoustic wave filter including a surface acoustic wave resonator connected in series with a surface acoustic wave filter section.

### 2. Description of the Related Art

Surface acoustic wave filters are widely used as a bandwidth filter in an RF stage in a mobile telephone.

For example, the applicant's earlier application EP 0 633 659 describes a surface acoustic wave filter including three IDTs sandwiched between two reflectors in the acoustic wave propagation direction, and having a surface acoustic wave resonator connected in series between the central IDT and an output terminal of the filter. In order to increase attenuation on the high-frequency side of the filter's passband, the antiresonance point of the surface acoustic wave resonator is at a frequency higher than the filter passband, the resonance point of the surface acoustic wave resonator is in the passband of the filter.

As another example, WO02/09279 describes a surface acoustic wave filter including two three-IDT filter sections, and having a surface acoustic wave resonator connected in series between the two filter sections. The surface acoustic wave resonator is configured as a notch filter and has an attenuation pole near the top (high-frequency end) of the passband.

As another example, Japanese Unexamined Patent Application Publication No. 7-30367 discloses another surface acoustic wave filter: FIG. 41 illustrates the construction of electrodes of the disclosed surface acoustic wave filter. In a surface acoustic wave filter 2001, a surface acoustic wave resonator 2003 is connected in series with a serially coupled 3-IDT (interdigital transducer) resonator type surface acoustic wave filter section 2002. The antiresonance frequency of the surface acoustic wave resonator 2003 is positioned on a high frequency side of the passband of the longitudinally coupled resonator type surface acoustic wave filter section 2002, while the resonance frequency of the surface acoustic wave resonator 2003 is positioned within the passband. Since the antiresonance frequency of the surface acoustic wave resonator 2003 is positioned on a high frequency side of the passband of the longitudinally coupled resonator type surface acoustic wave filter section 2002, attenuation in the vicinity of the high frequency side of the passband becomes large. Since the resonance frequency falls within the passband, transmission characteristic within the passband suffers from no large degradation.

If the surface acoustic wave filter 2001 is used as a wideband filter such as a DSC filter having a wide passband width, the VSWR (Voltage-Standing-Wave Ratio) in a high-frequency region of the passband is not high enough. The effect of parasitic capacitances generated in a piezoelectric substrate and a package becomes predominant in a high frequency region of the filter, and the impedance of the filter becomes capacitive if a wideband filter feature is implemented.

This trend becomes pronounced in the high frequency region of the passband. A threefold mode filter is typically used to widen band width. However, the frequency separation between three resonance modes naturally becomes large in an attempt to achieve the wideband feature. To balance impedance matching within the passband on the other hand, the impedance matching is performed on a center resonance mode out of the three resonance modes. The two remaining resonance modes in a low frequency and a high frequency region thus fall out of matching conditions. In high frequency applications in particular, the effect of capacitance in the resonance mode in the high frequency region is pronounced. The impedance of the filter becomes inductive on the resonance mode in the low frequency region while becoming capacitive on the resonance mode in the high frequency region. The resonance mode in the high frequency region tends to suffer from the effect of capacitance, thereby being subject to the above-mentioned problem. Published patent applications EP 1168614, JP H9-36695 and published patent US 6369674 disclose other conventional arrangements of surface acoustic wave filters having broadband characteristics.

Non-patent literature as cited below reveals important aspects related to the resonance modes of surface acoustic wave filters:
- Ivanov P. G. et al: "Wideband Low Loss SAW Filters for Telecommunication and Mobile Radio Applications", Ultrasonics Symp. Proc., 1996 IEEE San Antonio, TX, USA 3-6 Nov. 1996, IEEE, New York, USA, vol. 1, pages 61-64, ISBN: 978-0-7803-3615-5;
- Norita et al: "Wideband Low Loss Double Mode SAW Filters", Ultrasonics Symp. Proc., IEEE, New York, US, vol. 1, 20 October 1992, pages 95-104, ISSN: 0090-5607;
- Colin K Campbell: "Understanding Surface Acoustic Wave (SAW) Devices for Mobile and Wireless Applications and Design Techniques -- Session 19: "An Overview of SAW Devices For Mobile/Wireless Communications", 1 January 2008, pages 1-43, URL:http://www3.sympatico.ca/colin.kydd.campbell/.

### SUMMARY OF THE INVENTION

Accordingly, it is an object of the present invention to overcome the drawback of the conventional art, and to provide a surface acoustic wave filter which includes a surface acoustic wave resonator connected in series with a surface acoustic wave filter section and presents a good VSWR in a wide passband. According to the present invention, a surface acoustic wave filter includes
a surface acoustic wave filter section including a piezoelectric substrate, at least three interdigital transducers arranged in a direction of propagation of a surface acoustic wave on the piezoelectric substrate; and
at least one surface acoustic wave resonator connected in series between the surface acoustic wave filter section and one of an input signal terminal and an output signal terminal of the surface acoustic wave filter, wherein the surface acoustic filter section is a threefold mode surface acoustic wave filter section of a longitudinally coupled resonator type, any the impedance of the surface acoustic wave filter section is capacitive in the highest-frequency resonance mode out of the three resonance modes,
wherein the resonance frequency of the surface acoustic wave resonator is positioned within the passband of the surface acoustic wave filter section, and the antiresonance frequency of the surface acoustic wave resonator is positioned outside of the passband of the surface acoustic wave filer section and in the vicinity of the high frequency region of the passband of the surface acoustic wave filter section, and
wherein the surface acoustic wave resonator is formed so that the frequency band between said resonance frequency and said antiresonance frequency substantially coincides with the frequency band of said highest-frequency resonance mode.

Preferably, at least a portion of the IDT is weighted in an area where a plurality of IDTs are adjacent to each other in the surface acoustic filter section.

Weighting the portion of the IDT improves the out-of-passband characteristics of the filter. An arrangement featuring an unbalance-balance converting function compensates for an amplitude deviation and a phase shift from a phase difference of 180 DEG in a signal output from a circuit between an unbalanced signal terminal and one of the balanced signal terminals with respect to an input signal to a circuit between the unbalanced signal terminal and the other of the balanced signal terminals.

Preferably, the surface acoustic filter section includes an odd number of IDTs, and at least one surface acoustic wave resonator is connected between the surface acoustic wave filter section and one of the input signal terminal and the output signal terminal whichever has a larger number of IDTs connected thereto. The VSWR is further improved.

Preferably, the surface acoustic wave resonators include at least one surface acoustic wave resonator connected in series between the surface acoustic wave filter section and the input signal terminal, and at least one surface acoustic wave resonator connected in series between the surface acoustic wave filter section and the output signal terminal. The VSWR is further improved.

Preferably, a reflector is arranged between adjacent IDTs, the reflector having a plurality of electrode fingers at an electrode finger pitch different from the finger pitch of the IDTs. Preferably, the surface acoustic filter section includes an odd number of IDTs, and at least one surface acoustic wave resonator is connected between the surface acoustic wave filter section and one of the input signal terminal and the output signal terminal whichever has a larger number of IDTs connected thereto. The VSWR is thus further improved.

Preferably, the surface acoustic wave filter includes a plurality of surface acoustic wave resonators connected between the surface acoustic wave filter section and at least one of the input signal terminal and the output signal terminal.

At least one of the input signal terminal and the output signal terminal may include a pair of balanced signal terminals.

Preferably, the surface acoustic wave filter is configured to function as an unbalance-balance converter with one of the input signal terminal and output signal terminal being a balanced signal terminal, and the other of the input signal terminal and output signal terminal being an unbalanced signal terminal.

In certain preferred embodiments of the invention, two surface acoustic wave filter sections are provided including a first surface acoustic wave filter section and a second surface acoustic wave filter section, outputting respective output signals that differ from each other in phase by 180°, first terminals of the first and second surface acoustic wave filter sections are connected together, to form an unbalanced signal terminal, and second terminals of the first and second surface acoustic wave filter sections form balanced signal terminals.

In other preferred embodiments of the invention, a single surface acoustic wave filter section is provided, terminals of the surface acoustic wave filter section form a pair of balanced signal terminals, and the other terminal of the surface acoustic wave filter section forms an unbalanced signal terminal.

At least one IDT of the surface acoustic wave filter section may include first and second separate IDT sections split in a direction across the electrode finger or in a direction of propagation of a surface acoustic wave.

The surface acoustic wave resonator and the surface acoustic wave filter section may be formed on the same piezoelectric substrate. The surface acoustic wave resonator is thus produced into a single chip.

Preferably, the surface acoustic wave filter further includes a case plate, wherein the piezoelectric substrate is mounted on the case plate in a manner such that the side of the piezoelectric substrate bearing the surface acoustic wave filter section and the surface acoustic wave resonator faces the case plate. In accordance with the present invention, a surface acoustic wave filter device having a surface acoustic wave filter element mounted on the case plate is manufactured using a flip-chip technique.

In a third aspect of the present invention, a communications apparatus includes the surface acoustic wave filter of the present invention. The communications apparatus of the present invention employs a surface acoustic wave filter having a wide bandwidth and excellent VSWR.

Further features and advantages of the present invention will become apparent from reading the following description of preferred embodiments thereof, given by way of example, with reference to the accompanying drawings, in which:

### BRIEF DESCRIPTION OF THE DRAWINGS

FIG. 1 is a plan view diagrammatically showing an electrode structure of a surface acoustic wave filter of a first embodiment of the present invention;
FIG. 2 plots transmission characteristics of the surface acoustic wave filter of the first embodiment and the surface acoustic wave filter of a comparative example;
FIG. 3 plots input VSWR characteristics of the surface acoustic wave filter of the first embodiment and the surface acoustic wave filter of the comparative example;
FIG. 4 plots output VSWR characteristics of the surface acoustic wave filter of the first embodiment and the surface acoustic wave filter of the comparative example;
FIG. 5 plots, in a Smith chart, reflective characteristics S11 of the surface acoustic wave filter of FIG. 1;
FIG. 6 plots, in a Smith chart, reflective characteristics S22 of the surface acoustic wave filter of FIG. 1;
FIG. 7A plots the transmission characteristics of the surface acoustic wave filter of the first embodiment showing the relationship between a plurality of generated resonance modes and frequencies thereof, and FIG. 7B explains the resonance modes;
FIG. 8 is a plan view diagrammatically showing the surface acoustic wave filter of the first embodiment with a surface acoustic wave resonator removed therefrom;
FIG. 9 plots, in a Smith chart, reflective characteristics S11 of the surface acoustic wave filter having the structure shown in FIG. 8;
FIG. 10 plots, in a Smith chart, reflective characteristics S22 of the surface acoustic wave filter having the structure shown in FIG. 8;
FIG. 11 plots, in a Smith chart, the reflective characteristics S11 at the input of the surface acoustic wave filter of the comparative example;
FIG. 12 plots, in a Smith chart, the reflective characteristics S22 at the output of the surface acoustic wave filter of the comparative example;
FIG. 13 is a plan view showing the electrode structure of the surface acoustic wave filter of the first embodiment with two surface acoustic wave resonators removed therefrom;
FIG. 14 plots, in a Smith chart, the reflective characteristics S11 of the surface acoustic wave filter shown in FIG. 13;
FIG. 15 plots, in a Smith chart, the reflective characteristics S22 of the surface acoustic wave filter shown in FIG. 13;
FIG. 16 is a plan view showing the electrode structure of a surface acoustic wave filter which has three resonance modes without a narrow-pitched electrode finger portion;
FIG. 17 plots attenuation-frequency characteristics, explaining a resonance mode of a surface acoustic wave filter which has a spacing Y of 0.30λI between IDTs without narrow-pitched electrode finger portion;
FIG. 18 is a plan view diagrammatically showing the electrode structure of a surface acoustic wave filter in accordance with a modification of the first embodiment of the present invention;
FIG. 19 is a plan view diagrammatically showing the electrode structure of a surface acoustic wave filter in accordance with a modification of the first embodiment of the present invention;
FIG. 20 is a plan view diagrammatically showing the electrode structure of a surface acoustic wave filter in accordance with a modification of the first embodiment of the present invention;
FIG. 21 is a plan view diagrammatically showing the electrode structure of a surface acoustic wave filter in accordance with a modification of the first embodiment of the present invention;
FIG. 22 is a plan view diagrammatically showing the electrode structure of a surface acoustic wave filter in accordance with a modification of the first embodiment of the present invention;
FIG. 23 is a cross-sectional view diagrammatically showing the structure of the surface acoustic wave filter housed in a package;
FIG. 24 is a plan view diagrammatically showing the electrode structure of the surface acoustic wave filter in accordance with a second embodiment of the present invention;
FIG. 25 plots transmission characteristics of the surface acoustic wave filter of the second embodiment;
FIG. 26 plots input VSWR characteristics of the surface acoustic wave filter of the second embodiment;
FIG. 27 plots output VSWR characteristics of the surface acoustic wave filter of the second embodiment;
FIG. 28 plots, in a Smith chart, reflective characteristics S11 at the input of the surface acoustic wave filter of the second embodiment;
FIG. 29 plots, in a Smith chart, reflective characteristics S22 at the output of the surface acoustic wave filter of the second embodiment;
FIG. 30 is a plan view showing a modification of the surface acoustic wave filter of the second embodiment;
FIG. 31 is a plan view showing another modification of the surface acoustic wave filter of the second embodiment;
FIG. 32 is a plan view showing yet another modification of the surface acoustic wave filter of the second embodiment;
FIG. 33 is a plan view showing yet a further modification of the surface acoustic wave filter of the second embodiment;
FIG. 34 is a plan view showing yet a further modification of the surface acoustic wave filter of the second embodiment;
FIG. 35 is a plan view showing yet a further modification of the surface acoustic wave filter of the second embodiment;
FIG. 36 is a plan view showing yet a further modification of the surface acoustic wave filter of the second embodiment;
FIG. 37 is a plan view diagrammatically showing the electrode structure of the surface acoustic wave filter of a third embodiment of the present invention;
FIG. 38 is a plan view diagrammatically showing the electrode structure of a modification of the surface acoustic wave filter of the third embodiment;
FIG. 39 is a plan view diagrammatically showing the electrode structure of the surface acoustic wave filter in accordance with a fourth embodiment of the present invention;
FIG. 40 is a plan view diagrammatically showing the electrode structure of a surface acoustic wave filter of a variant of the second embodiment of the present invention; and

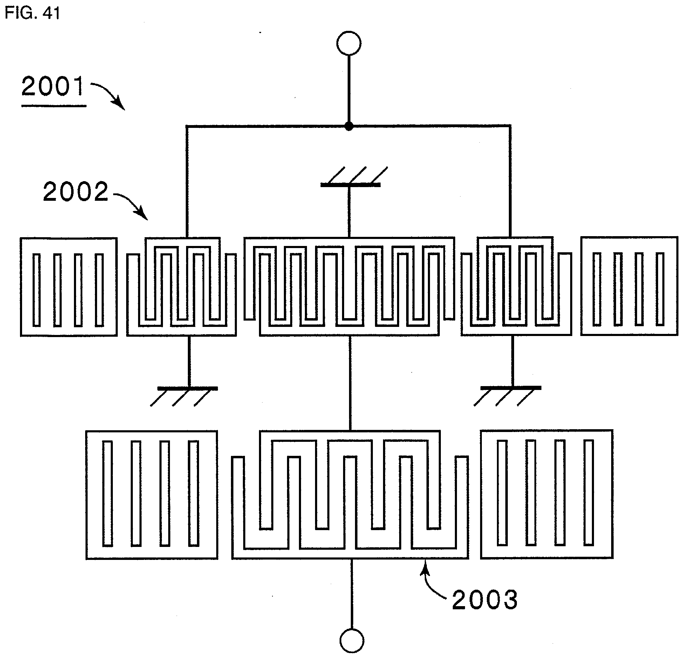

FIG. 41 is a plan view showing the electrode structure of a conventional surface acoustic wave filter device.

### DESCRIPTION OF THE PREFERRED EMBODIMENTS

The embodiments of the present invention will now be discussed.

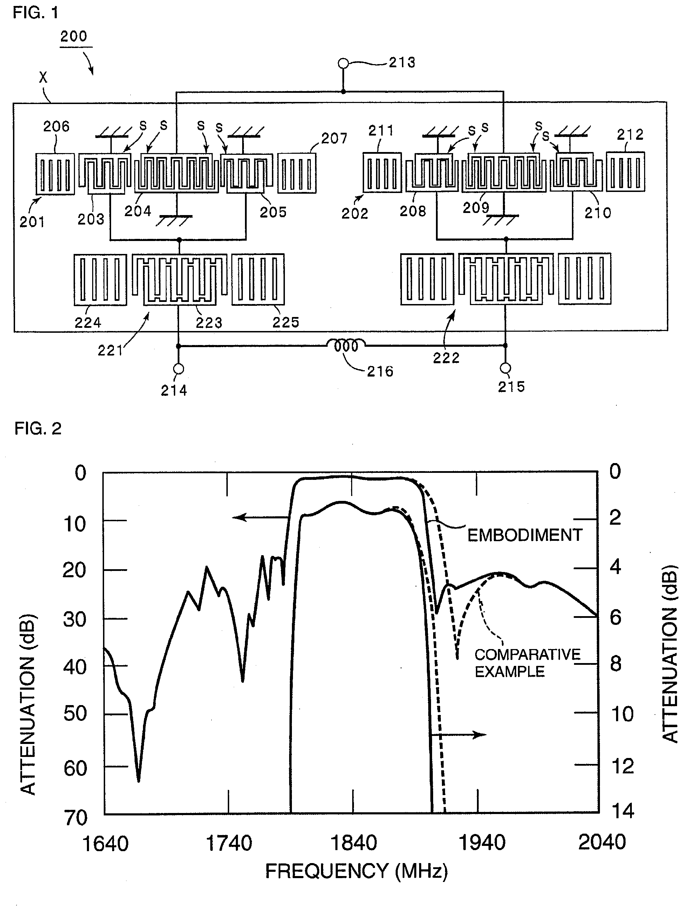

FIG. 1 is a plan view diagrammatically showing an electrode structure of a surface acoustic wave filter of a first embodiment of the present invention. In the first embodiment, the present invention is applied to a surface acoustic wave filter having unbalance-balance converting function, for example for DSC receiving. In the present illustrative example, the impedance of the unbalanced signal terminals is 50 Ω while the impedance of the balanced signal terminals is 150 Ω.

As shown, an electrode structure, fabricated of Al, is arranged on a piezoelectric substrate X (with only the outline thereof diagrammatically shown). The piezoelectric substrate X is a 40 ± 5° Y-cut, X-propagating LiTaO₃ substrate.

A longitudinally coupled resonator type surface acoustic wave filter section 201 includes IDTs 203 through 205 arranged in a direction of propagation of a surface acoustic wave. Reflectors 206 and 207 are respectively arranged at both ends of a region bearing the IDTs 203 through 205 along the direction of propagation of the surface acoustic wave.

As shown in FIG. 1, each IDT has several electrode fingers at an end thereof having an electrode finger pitch narrower, in an area where the IDTs 203 and 204 are adjacent to each other and in an area where the IDTs 204 and 205 are adjacent to each other, than an electrode finger pitch of the remaining portion of each IDT. Specifically, narrow-pitched electrode finger portions represented by the arrows S in FIG. 1 are formed. With the narrow-pitched electrode finger portion arranged in each of the IDTs 203 through 205, insertion loss in the passband of the filter is reduced.

Like the longitudinally coupled resonator type surface acoustic wave filter section 201, a longitudinally coupled resonator type surface acoustic wave filter section 202 also includes three IDTs 208 through 210 and reflectors 211 and 212. A narrow-pitched portion represented by the arrow S is also arranged in each of the IDTs 208 through 210 in an area where the IDTs 208 and 209 are adjacent to each other and in an area where the IDTs 209 and 210 are adjacent to each other.

The IDTs 208 and 210 in the longitudinally coupled resonator type surface acoustic wave filter section 202 are inverted with respect to the IDTs 203 and 205 in the longitudinally coupled resonator type surface acoustic wave filter section 201. Specifically, the phase of an output signal of the longitudinally coupled resonator type surface acoustic wave filter section 202, responsive to a signal input thereto, is shifted by 180° from an output signal from the longitudinally coupled resonator type surface acoustic wave filter section 201.

Referring to FIG. 1, an input terminal is an unbalanced signal terminal 213, while output terminals are a pair of balanced signal terminals 214 and 215. An inductance element 216 is connected between the balanced signal terminals 214 and 215. In the present illustrative example of the first embodiment, an inductance element of 18 nH is used for the inductance element 216.

A surface acoustic wave resonator 221 is serially connected between the longitudinally coupled resonator type surface acoustic wave filter section 201 and the balanced signal terminal 214. Similarly, a surface acoustic wave resonator 222 is connected between the longitudinally coupled resonator type surface acoustic wave filter section 202 and the balanced signal terminal 215.

Specifically, in the first embodiment, the IDTs 203 and 205 in the longitudinally coupled resonator type surface acoustic wave filter section 201 are connected to the surface acoustic wave resonator 221. Also in the longitudinally coupled resonator type surface acoustic wave filter section 202, the IDTs 208 and 210 are connected to the surface acoustic wave resonator 222.

The surface acoustic wave resonator 221 has reflectors 224 and 225 respectively at both ends of a single IDT 223 in the direction of propagation of the surface acoustic wave. The surface acoustic wave resonator 221 is a one-port type surface acoustic wave resonator having reflectors. The surface acoustic wave resonator 222 has also an identical structure.

Alternatively, surface acoustic wave resonators 221 and 222 having no reflector may be used.

To simplify the drawings, the number of electrode fingers in each of the longitudinally coupled resonator type surface acoustic wave filter sections 201 and 202, and surface acoustic wave resonators 221 and 222 in FIG. 1 is smaller than the actual number of electrode fingers.

In the first embodiment, the surface acoustic wave resonators 221 and 222 are identical to each other in structure. The resonance frequencies of the surface acoustic wave resonators 221 and 222 fall within the passbands of the longitudinally coupled resonator type surface acoustic wave filter sections 201 and 202, respectively, and the antiresonance frequencies of the surface acoustic wave resonators 221 and 222 are positioned in the vicinities of the high frequency sides of the passbands of the longitudinally coupled resonator type surface acoustic wave filter sections 201 and 202, respectively. As test results will show later, the use of the surface acoustic wave resonators 221 and 222 places, close to an impedance matching point at each of an input terminal and an output terminal, each of the impedances of the longitudinally coupled resonator type surface acoustic wave filter sections 201 and 202 in a resonance mode in the highest frequency region, out of resonance modes thereof. VSWR characteristics are thus improved. The tests are specifically discussed.

A specific example of the design of the longitudinally coupled resonator type surface acoustic wave filter section 201 of the first embodiment will be discussed below. In the first embodiment, the electrode finger pitches in the narrow-pitched electrode finger portions of the IDTs 203 through 205 and IDTs 208 through 210 are equalized. Let λI1 represent the surface acoustic wave determined by the electrode finger pitch of the remaining portion other than the narrow-pitched electrode finger portion.

Design specifications of the filter according to this illustrative example are as follows:
Transverse width W = 41.8λI1
Electrode fingers of each of the IDTs 203 and 205:
   number of electrode fingers in the narrow-pitched electrode finger portion = 3 and
   number of electrode fingers in the remaining electrode finger portion = 18
Electrode fingers of the IDT 204: number of electrode fingers in the narrow-pitched electrode finger portion = 3 (in each portion adjacent to the IDTs 203 and 205), and number of electrode fingers in the remaining electrode finger portion = 33
Number of electrode fingers in each of the reflectors 206 and 207 = 90 Duty factor of each of the IDTs = 0.72
Duty factor of each of the reflectors 206 and 207 = 0.57
Thickness of the electrode finger = 0.092λI1

The longitudinally coupled resonator type surface acoustic wave filter section 202 is identical in construction to the longitudinally coupled resonator type surface acoustic wave filter section 201 except that the alignment of the IDTs 208 and 210 are opposite to the alignment of the IDTs 203 and 205, and that the number of electrode fingers of the reflector is 60.

Optionally, the longitudinally coupled resonator type surface acoustic wave filter sections 201 and 202 may be different in design to improve the degree of balance between the balanced signal terminals 214 and 215, and to increase attenuation in the stopband. As long as such an optional design satisfies the construction of the present invention, the advantage of the present invention is still provided.

The design specifications of the surface acoustic wave resonators 221 and 222 are as follows:
Transverse width = 23.6λ
Number of electrode fingers of the IDT = 241
Number of electrode fingers of the reflector = 30
Duty factor = 0.60
Electrode thickness = 0.093λ

The surface acoustic wave resonators 221 and 222 are identical to each other in construction. Optionally, the surface acoustic wave resonators 221 and 222 may be different in design from each other to improve the degree of balance between the balanced signal terminals 214 and 215, and to increase attenuation in the stopband. Such an optional design still provides the advantage of the present invention as long as the resonance frequency falls within the passband of each of the longitudinally coupled resonator type surface acoustic wave filter sections 201 and 202, and the antiresonance frequency is positioned in the vicinity of the high frequency region of the passband.

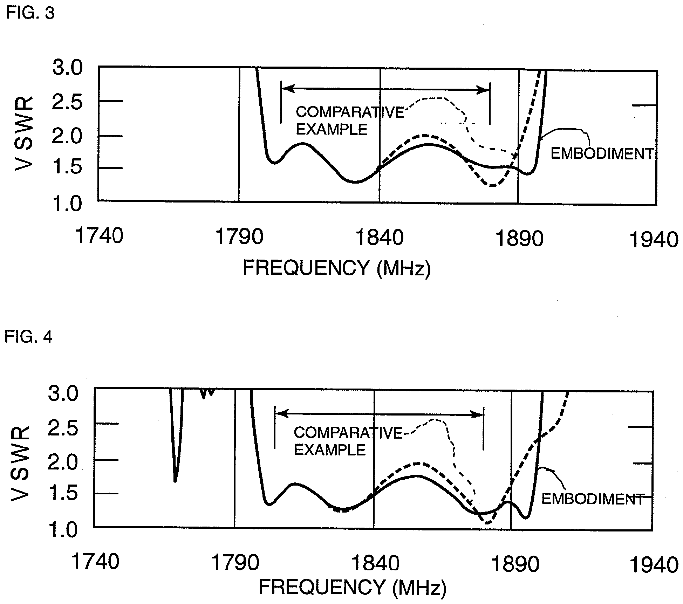

FIG. 2 plots, in solid line, transmission characteristics of the surface acoustic wave filter 200 thus constructed in accordance with the first embodiment of the present invention. FIG. 3 plots, in solid line, VSWR characteristics of the surface acoustic wave filter 200 at the input side thereof (at the unbalanced terminal 213), and FIG. 4 plots, in solid line, VSWR characteristics of the surface acoustic wave filter 200 at the output side thereof (at the balanced signal terminals 214 and 215). For comparison, characteristics of the surface acoustic wave filter of a comparative example are identified by broken lines in FIGS. 2 through 4.

The surface acoustic wave filter of the comparative example has a conventional structure in which the surface acoustic wave resonators 221 and 222 are respectively connected in series with the longitudinally coupled resonator type surface acoustic wave filter sections 201 and 202 so that the attenuation in the high frequency region of the passband increases. In the comparative example, the wavelength determined by the pitch of the surface acoustic wave resonators 221 and 222 is shortened by 1%. The rest of the construction of the comparative example remains unchanged from the first embodiment of the present invention.

The frequency range of the passband of a DCS receiving filter is 1805 to 1880 MHz. If the VSWR characteristics of the surface acoustic wave filters of the first embodiment and the comparative example are compared within that frequency range, the first embodiment has improvements over the comparative example as shown in FIGS. 3 and 4. Specifically, the comparative example results in a VSWR of 2.1 at the input and a VSWR of 1.9 at the output while the first embodiment results in a VSWR of 1.8 at the input and a VSWR of 1.7 at the output. The first embodiment presents improvements of VSWR by 0.3 at the input and 0.2 at the output over the comparative example. As shown in FIG. 2, the surface acoustic wave filter of the first embodiment is degraded in attenuation of transmission characteristics by about 1 dB with respect to the comparative example within a region (1920-1980 MHz) at a higher frequency than the passband, but there is no significant difference within the passband.

The surface acoustic wave filter of the first embodiment improves the VSWR over the surface acoustic wave filter of the comparative example without degrading the transmission characteristics of the passband too much.

The reason why such an advantage is provided is discussed below.

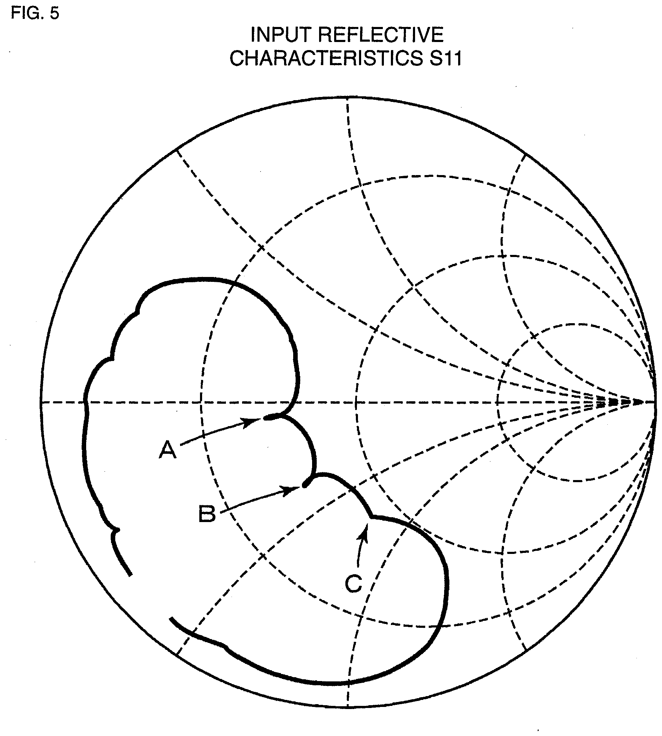

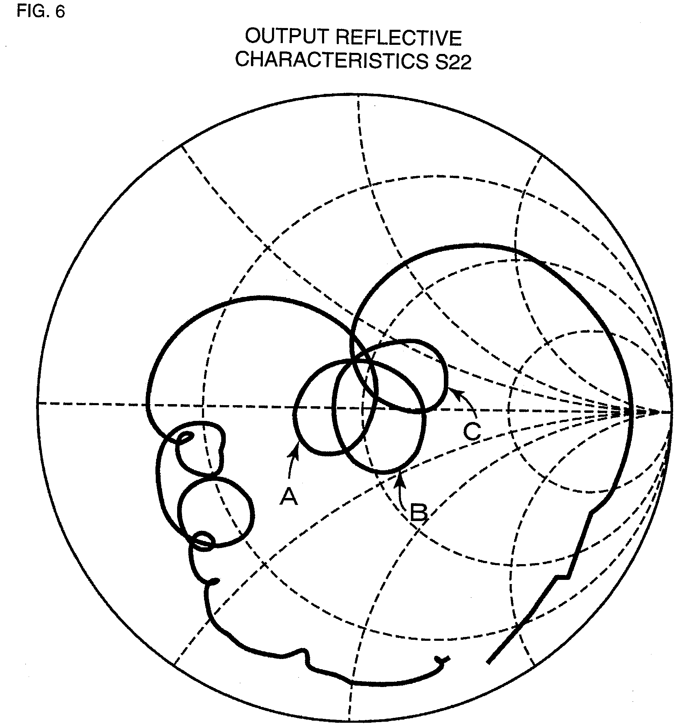

FIG. 5 plots, in a Smith chart, reflective characteristics S11 of the surface acoustic wave filter at the input thereof, and FIG. 6 plots, in a Smith chart, reflective characteristics S22 of the surface acoustic wave filter at the output thereof. FIGS. 5 and 6 show that resonance modes A through C are available. Specifically, the surface acoustic wave filter 200 is a longitudinally coupled resonator type threefold mode surface acoustic wave filter.

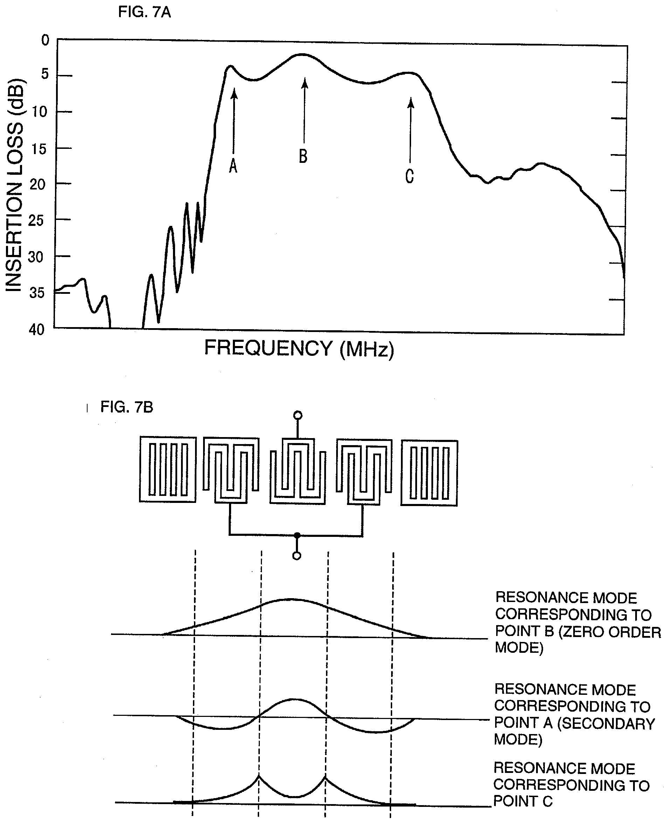

FIG. 7A plots the transmission characteristics of the surface acoustic wave filter of the first embodiment in a wider frequency range. The resonance modes identified by the arrows A through C are shown in the attenuation-frequency characteristics. Referring to FIG. 7B, the longitudinally coupled resonator type surface acoustic wave filter having three IDTs forms a passband of three modes, namely, a zero-order mode (the resonance mode identified by the arrow B), a secondary mode (the resonance mode identified by the arrow A), and a mode (identified by the arrow C) having a peak in the intensity distribution of the surface acoustic wave.

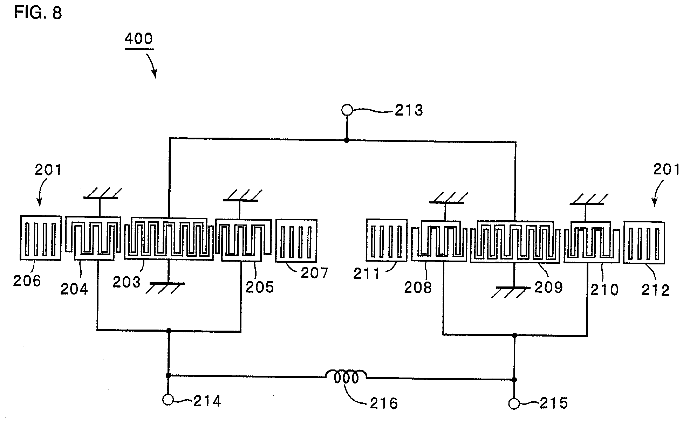

A longitudinally coupled resonator type surface acoustic wave filter 400 is manufactured by removing the surface acoustic wave resonators 221 and 222 from the surface acoustic wave filter 200 as shown in FIG. 8. The surface acoustic wave filter 400 employs only longitudinally coupled resonator type surface acoustic wave filter sections 201 and 202.

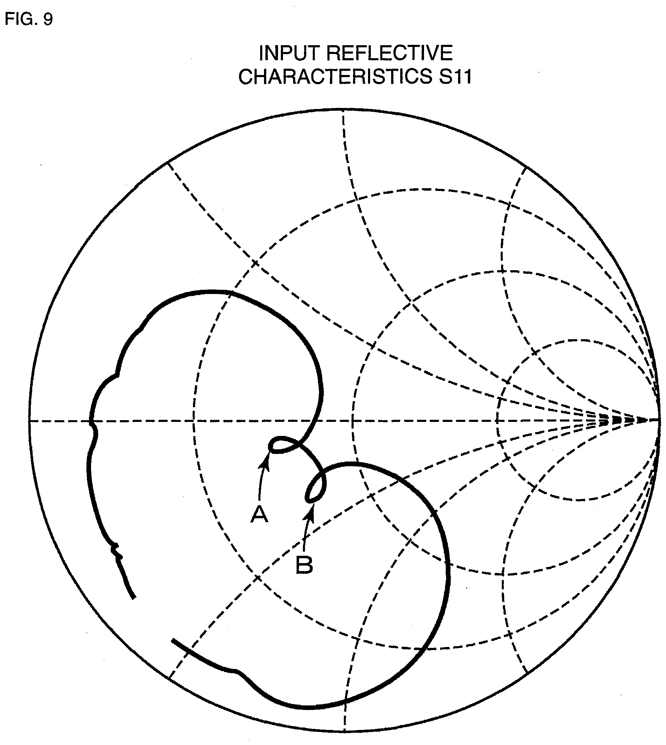

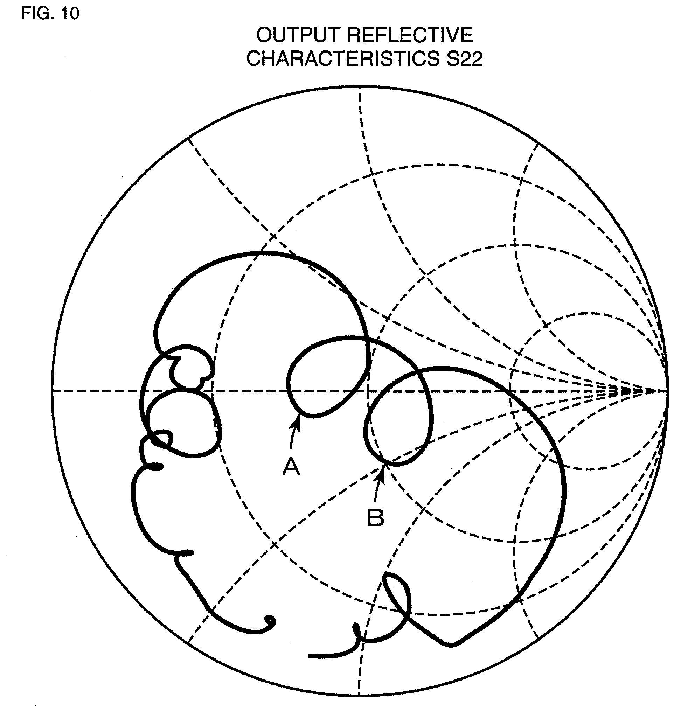

FIGS. 9 and 10 are Smith charts respectively showing reflective characteristics S11 of the surface acoustic wave filter 400 at the input thereof and reflective characteristics S22 of the surface acoustic wave filter 400 at the output thereof. A comparison of FIGS. 9 and 10 with FIGS. 5 and 6 reveals that the resonance mode C disappears. This does not means that the resonance mode C is non-existent. The resonance mode C is simply not recognized in the Smith chart because the resonance mode C is generated at a location far apart from the impedance matching point.

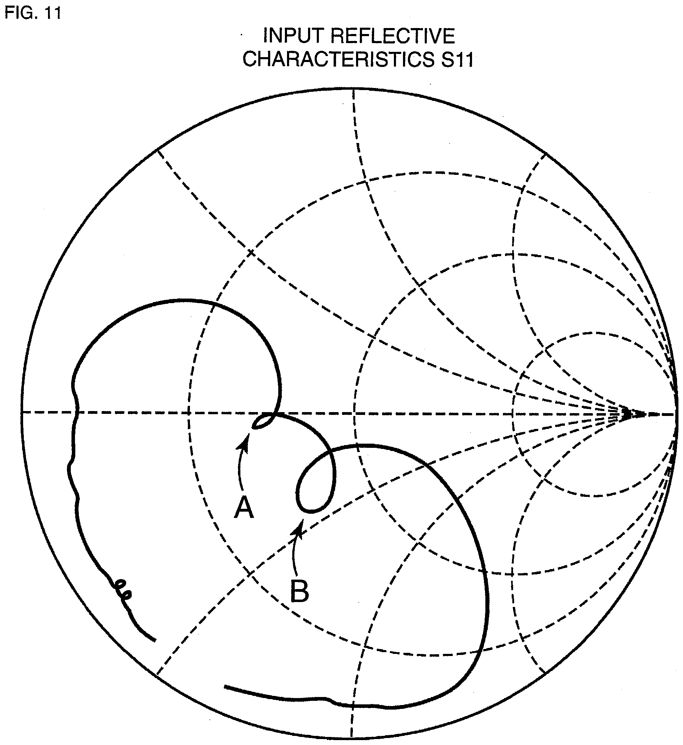

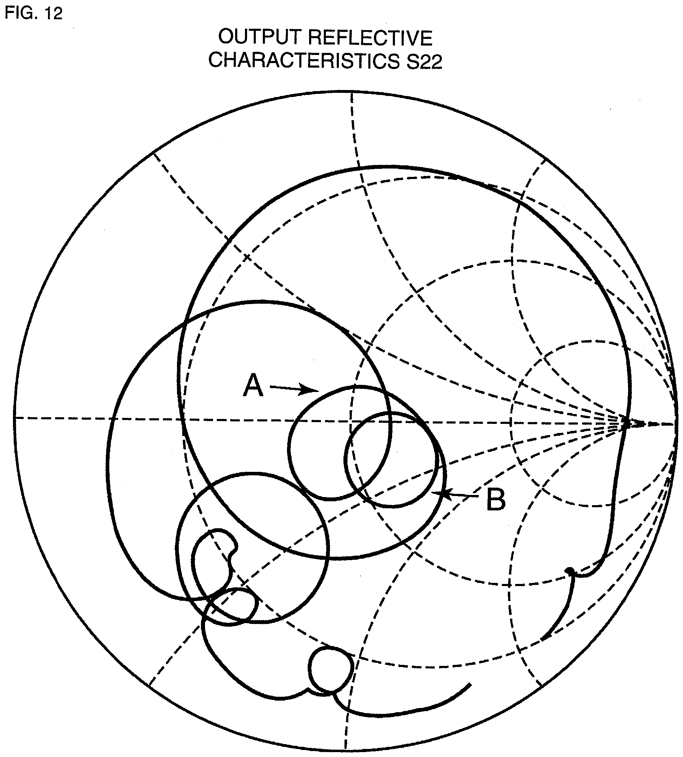

Similarly, FIGS. 11 and 12 are Smith charts respectively showing reflective characteristics S11 of the comparative example at the input thereof and reflective characteristics S22 of the comparative example at the output thereof. A comparison of FIGS. 11 and 12 with FIGS. 5 and 6 reveals that the resonance mode C is not recognized as in the reflective characteristics of the surface acoustic wave filter 400 shown in FIG. 8. Since the surface acoustic wave resonators 221 and 222 are constructed to attain attenuation in the high frequency side of the passband in the surface acoustic wave filter of the comparative example, the resonance mode C of the longitudinally coupled resonator type surface acoustic wave filter sections 201 and 202 is not sufficiently close to the impedance matching point. In other words, the surface acoustic wave filter 200 of the first embodiment includes the surface acoustic wave resonators 221 and 222 in which the resonance mode C is set to be close to the impedance matching point. The VSWR characteristics are thus improved.

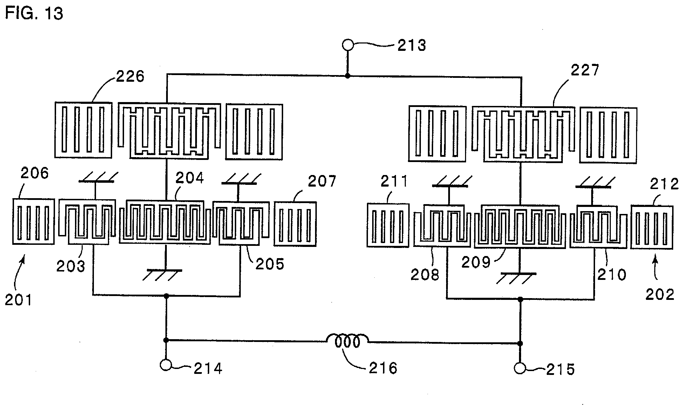

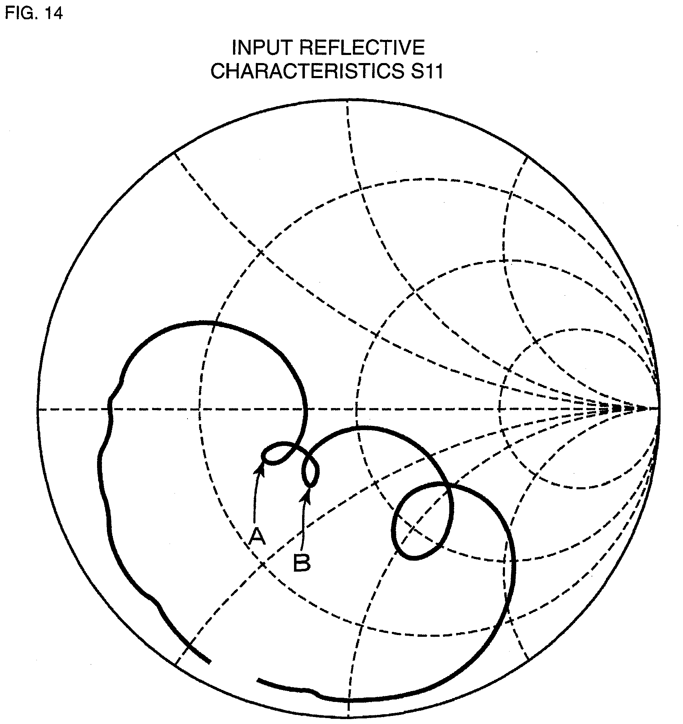

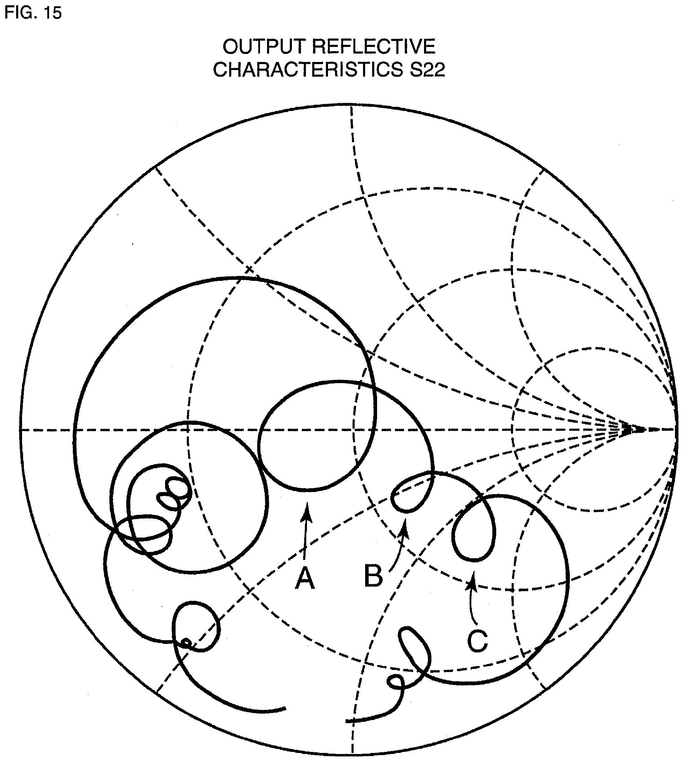

In view of the results shown in FIGS. 9 and 10, the inventors of the present invention have studied the manner of connection of the surface acoustic wave resonators to the longitudinally coupled resonator type surface acoustic wave filter sections 201 and 202. Referring to FIG. 13, surface acoustic wave resonators 226 and 227 are respectively connected to the inputs of the longitudinally coupled resonator type surface acoustic wave filter sections 201 and 202. FIGS. 14 and 15 are Smith charts respectively showing reflective characteristics S11 and S22 of the filter.

As understood from FIGS. 14 and 15, the resonance mode C appears in the reflective characteristics S22 when the surface acoustic wave resonators are connected to the input of the filter. The resonance mode C is not recognized in the reflective characteristics S11 since the resonance mode C is spaced apart from the impedance matching point. The VSWR is not sufficiently improved in comparison with the first embodiment.

The first embodiment efficiently improves the VSWR by connecting the surface acoustic wave resonator to the input terminal or the output terminal of each of the longitudinally coupled resonator type surface acoustic wave filter sections 201 and 202, whichever has a larger number of IDTs connected thereto.

In accordance with the present invention, each of the longitudinally coupled resonator type surface acoustic wave filter sections 201 and 202 has the above-referenced narrow-pitched electrode finger portions. The insertion loss within the passband is thus reduced, and the present invention has further a pronounced effect as discussed below.

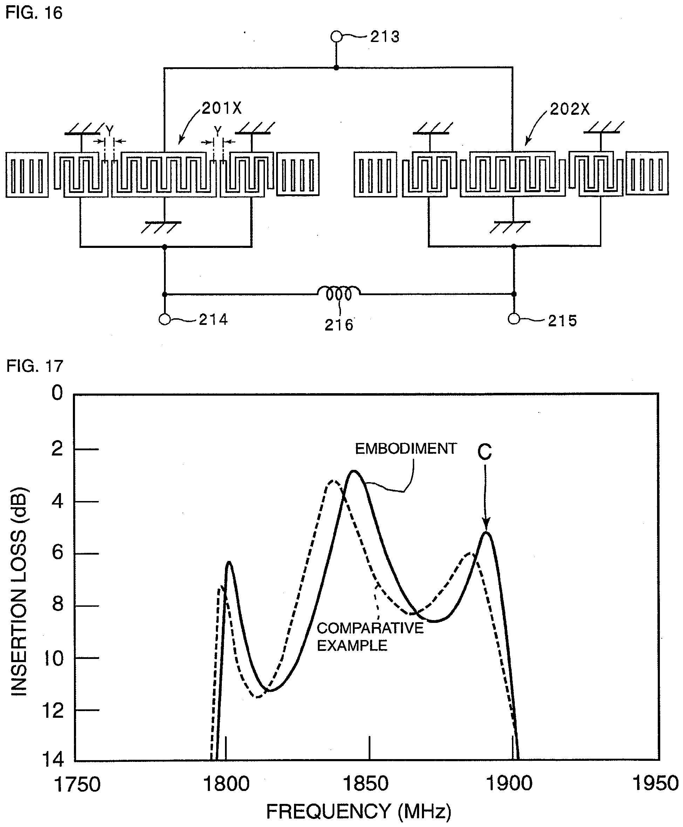

To use the above-referenced resonance modes without the narrow-pitched electrode fingers, as illustrated in Fig.16, the spacing Y between the adjacent IDTs having no narrow-pitched electrode portion in each of the longitudinally coupled resonator type surface acoustic wave filter sections 201X and 202X must be placed within a range of (0.25 + 0.5n)λI to (0.30 + 0.5n)λI (n = 0, 1, 2,...). In this arrangement, a large discontinuity point occurs in the surface acoustic wave propagation path, and the insertion loss within the passband increases. In particular, the resonance mode C is adversely affected by the discontinuity in the propagation path, because the resonance mode C has a peak in current distribution in an area where the IDTs are adjacent to each other.

FIG. 17 plots, in broken line, the resonance modes in the attenuation-frequency characteristics of the surface acoustic wave filter which has no narrow-pitched electrode fingers with the spacing Y between the adjacent IDTs set to be 0.30λI. In this arrangement, each of the IDTs includes electrode fingers at a pitch equal to a pitch of the remaining portion, instead of the narrow-pitched electrode finger portion, and has the same total number of electrode fingers as the first embodiment.

FIG. 17 also plots the characteristics of the surface acoustic wave filter 200 of the first embodiment in solid line together with the characteristics of the longitudinally coupled resonator type surface acoustic wave filter of the comparative example identified in broken line.

As understood from FIG. 17, the filter with the spacing between the adjacent IDTs being at 0.30λI has more insertion loss in the resonance mode C and decreases quality factor Q compared with the filter of the first embodiment. A reduced quality factor Q distorts the right edge, namely, the high-frequency edge of the passband response, even if the resonance mode C is impedance matched. This enlarges the insertion loss. To avoid enlarging the insertion loss, the passband width must be widened. If the passband width is widened, the VSWR characteristics are degraded. The advantage of the present invention is not sufficiently exploited. To provide the advantage of the present invention using the configuration of the first embodiment, the longitudinally coupled resonator type surface acoustic wave filter sections 201 and 202 must employ the narrow-pitched electrode finger portions.

As described above, the longitudinally coupled resonator type surface acoustic wave filter 200 includes three IDTs 203 through 205 and three IDTs 208 through 210 arranged in the direction of propagation of the surface acoustic wave on the piezoelectric substrate, and the longitudinally coupled resonator type surface acoustic wave filter sections 201 and 202, each having the narrow-pitched electrode finger portion. The surface acoustic wave resonators 221 and 222 are respectively connected to the outputs of the longitudinally coupled resonator type surface acoustic wave filter sections 201 and 202, namely, the terminals having a larger number of IDTs connected thereto. The resonance frequency of the surface acoustic wave resonators 221 and 222 falls within the passband of the longitudinally coupled resonator type surface acoustic wave filter sections 201 and 202, and the antiresonance frequency of the surface acoustic wave resonators 221 and 222 is placed outside of the passband in the vicinity of the high frequency side of the passband. The use of the surface acoustic wave resonator places the impedance of the resonance mode C within the highest frequency region of the surface acoustic wave filter 200 close to the impedance matching point. As a result, the VSWR is improved without significantly degrading the transmission characteristic in the passband.

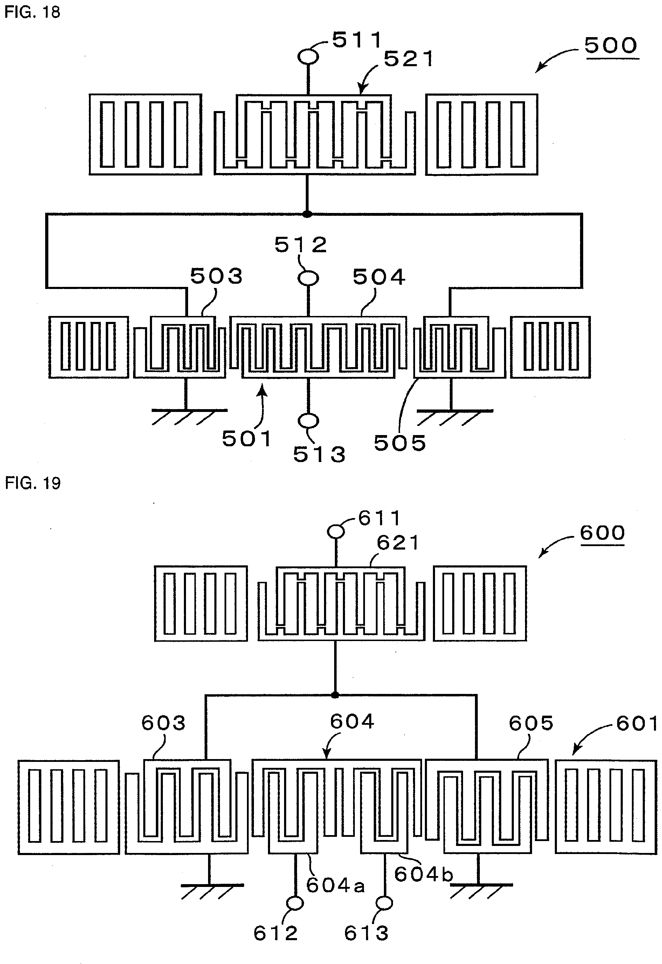

FIGS. 18 through 22 are plan views diagrammatically showing the electrode structures of surface acoustic wave filters in accordance with modifications of the first embodiment of the present invention.

A surface acoustic wave filter 500 shown in FIG. 18 is one modification of the first embodiment having an unbalance-balance converting function. Here, a longitudinally coupled resonator type surface acoustic filter section 501 includes three IDTs 503 through 505. A surface acoustic wave resonator 521 is serially connected to IDTs 503 and 505, and is also connected to an unbalanced signal terminal 511. A pair of balanced signal terminals 512 and 513 are connected to both ends of the center IDT 504.

A surface acoustic wave filter 600 shown in FIG. 19 employs a longitudinally coupled resonator type surface acoustic wave filter section 601 including three IDTs. The center IDT 604 from among the three IDTs 603 through 605 has two separate IDT sections 604a and 604b arranged in the direction of propagation of the surface acoustic wave. An unbalanced signal terminal 611 is connected to the IDTs 603 and 605 through a surface acoustic wave resonator 621. A pair of balanced signal terminals are respectively connected to the IDT sections 604a and 604b of the IDT 604.

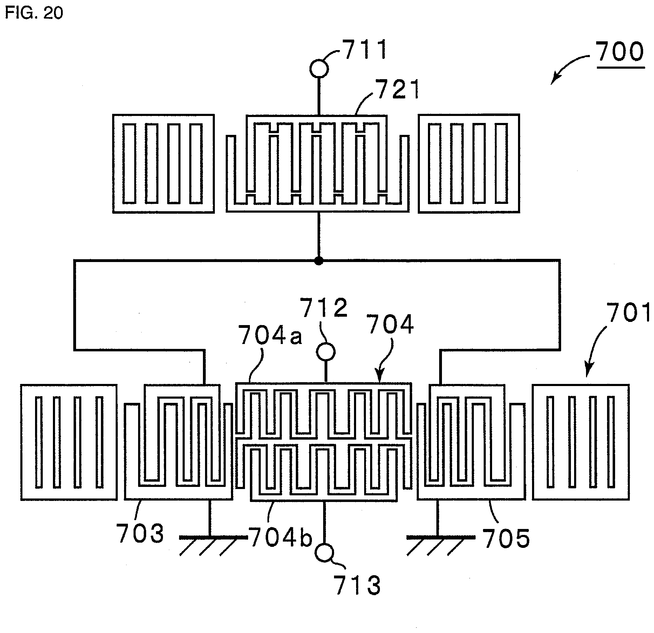

Unlike the surface acoustic wave filter 600 shown in FIG. 19, a surface acoustic wave filter 700 shown in FIG. 20 has a longitudinally coupled resonator type surface acoustic wave filter section 701 which includes a center IDT 704 that includes two separate IDTs 704a and 704b split along a line transversely extending across the electrode fingers. A pair of balanced signal terminals 712 and 713 are respectively connected to the IDT sections 704a and 704b. Outside IDTs 703 and 705, which are commonly connected, are connected to an unbalanced signal terminal 711 through a surface acoustic wave resonator 721.

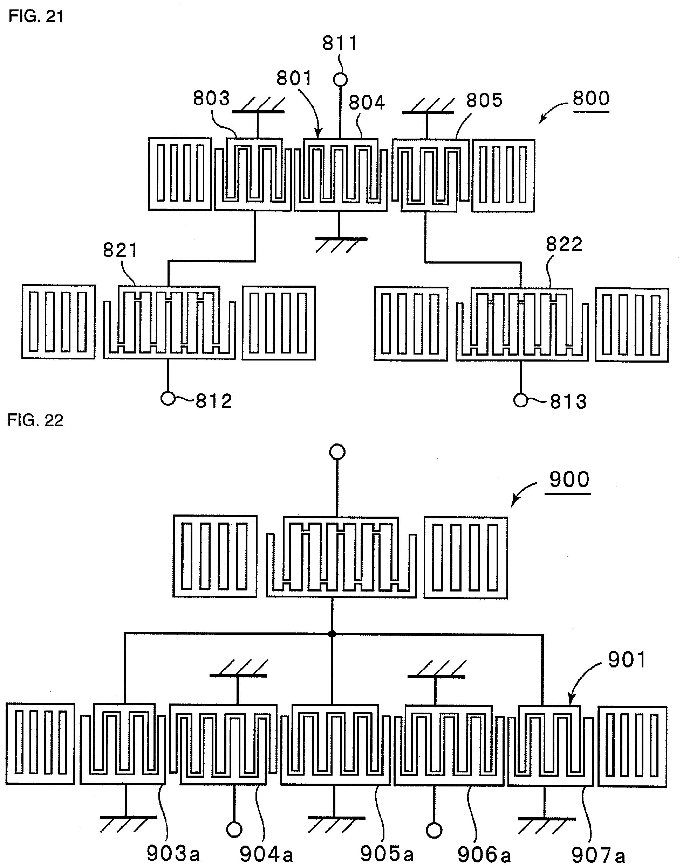

In a surface acoustic wave filter 800 shown in FIG. 21, an unbalanced signal terminal 811 is connected to a center IDT 804 of a longitudinally coupled resonator type surface acoustic wave filter section 801. IDTs 803 and 805 on both sides of the center IDT 804 are respectively connected to balanced signal terminals 812 and 813 through surface acoustic wave resonators 821 and 822. The IDT 803 and IDT 805 are aligned to be opposite in polarity from each other.

The surface acoustic wave filter 800 shown in FIG. 21 has the three IDTs 803 through 805. In an alternative arrangement, a surface acoustic wave filter 900 of a modification of the first embodiment shown in FIG. 22 employs a longitudinally coupled resonator type surface acoustic wave filter section 901 including five IDTs 903a-907a.

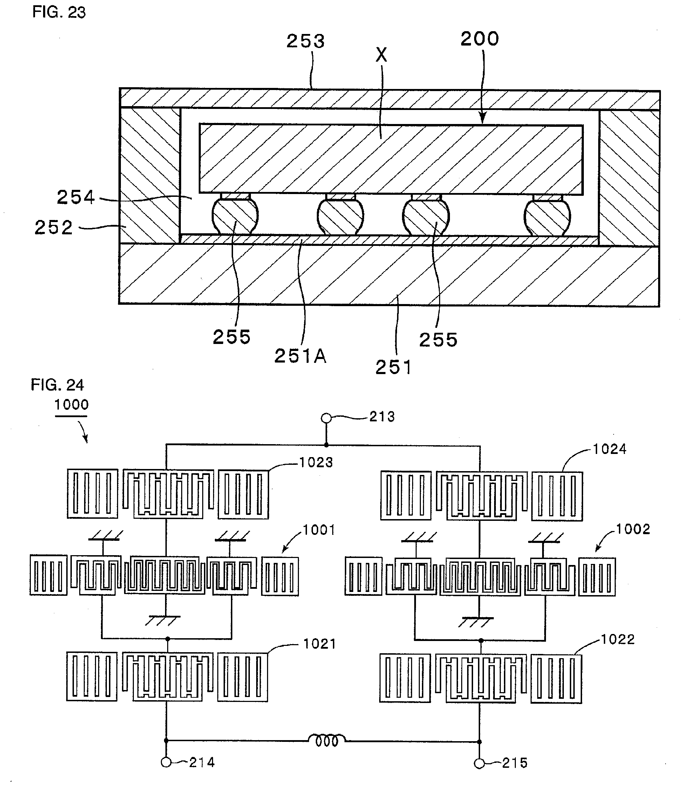

A variety of package structures may be employed when the longitudinally coupled resonator type surface acoustic wave filter is packaged. For example, a package, which is formed of a bottom plate 251, a circular wall 252 secured onto the bottom plate 251, and a planar cap member 253 for closing the top opening of the circular wall 252 as shown in FIG. 23 may be used. The longitudinally coupled resonator type surface acoustic wave filter formed on a piezoelectric substrate X is secured on the bottom plate 251 within the space 254 in the package using a flip-chip technique. As diagrammatically shown in FIG. 23, a variety of various electrodes 251A to be connected to the surface acoustic wave filter 200 are formed on the top surface of the bottom plate 251. The surface acoustic wave filter 200 is mechanically and electrically connected to the bottom plate 251 using bumps 255 with the surface of the piezoelectric substrate X bearing the longitudinally coupled resonator type surface acoustic wave filter section 201 facing downward.

It is not a requirement in the surface acoustic wave filter of the present invention that the electrodes formed on the piezoelectric substrate be electrically connected to the package using bump bonding. The electrodes formed on the piezoelectric substrate may be electrically connected to the package using wire bonding. In a structure in which the electrodes of the piezoelectric substrate are electrically connected to the package using the wire bonding, the impedance of the filter is likely to be inductive because of an impedance component of wires. In the structure in which the piezoelectric substrate is mounted onto the package using the flip-chip technique as shown in FIG. 23, the impedance is likely to be capacitive because inductance of wires does not exit. The longitudinally coupled resonator type surface acoustic wave filter 200 which is supported in the package using the flip-chip technique as shown in FIG. 23 provides the advantage of the present invention to an even greater extent.

In the first embodiment, the 40 ± 5° Y-cut, X-propagating LiTaO₃ substrate is used for the piezoelectric substrate X. Alternatively, another substrate such as a 64-72° Y-cut, X-propagating LiNbO₃ substrate or a 41° Y-cut, X-propagating LiNbO₃ substrate may be used.

FIG. 24 is a plan view diagrammatically showing the surface acoustic wave filter 1000 in accordance with a second embodiment of the present invention. In addition to the construction of the first embodiment, the surface acoustic wave filter of the second embodiment includes a surface acoustic wave resonator 1023 connected between a longitudinally coupled resonator type surface acoustic wave filter sections 1001 and an unbalanced signal terminal 213 and a surface acoustic wave resonator 1024 connected between a longitudinally coupled resonator type surface acoustic wave filter section 1002 and the unbalanced signal terminal 213. The longitudinally coupled resonator type surface acoustic wave filter sections 1001 and 1002 are substantially identical in design to the longitudinally coupled resonator type surface acoustic wave filter sections 201 and 202 except a slight difference in finger pitch in the narrow-pitched electrode finger portion. Surface acoustic wave resonators 1021 through 1024 are identical in design to the surface acoustic wave resonators 221 and 222.

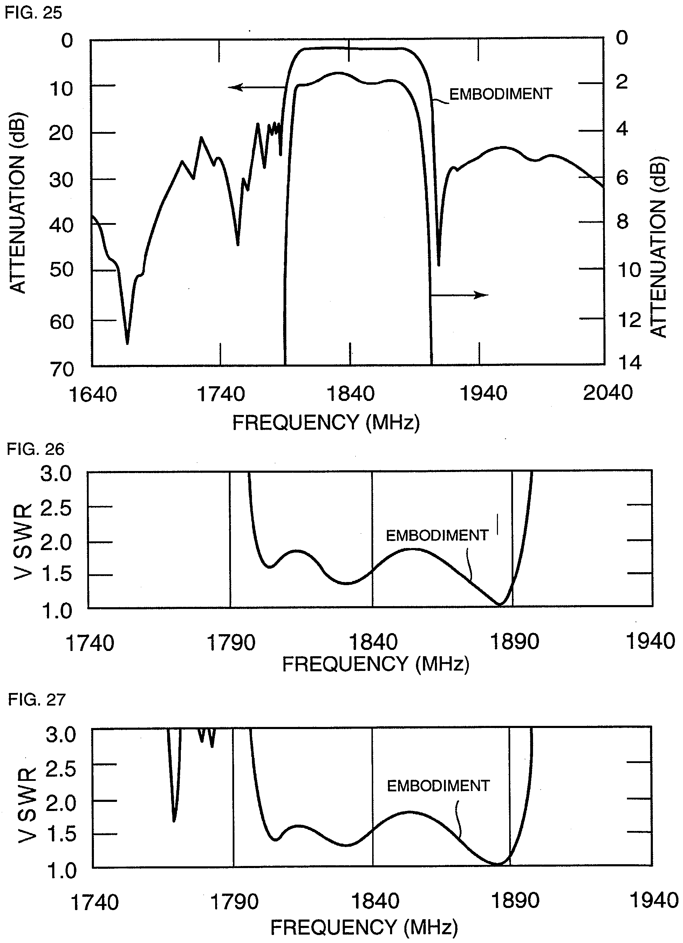

FIG. 25 plots the transmission characteristics of the surface acoustic wave filter 1000 of the second embodiment thus constructed. FIG. 26 plots the VSWR characteristics of the surface acoustic wave filter 1000 at the input thereof (the unbalanced signal terminal 213), and FIG. 27 plots the VSWR characteristics of the surface acoustic wave filter 1000 at the output thereof (the balanced signal terminals 214 and 215).

The surface acoustic wave filter 1000 shown in FIG. 24 presents better VSWR characteristics than the first embodiment without degrading the passband characteristics thereof.

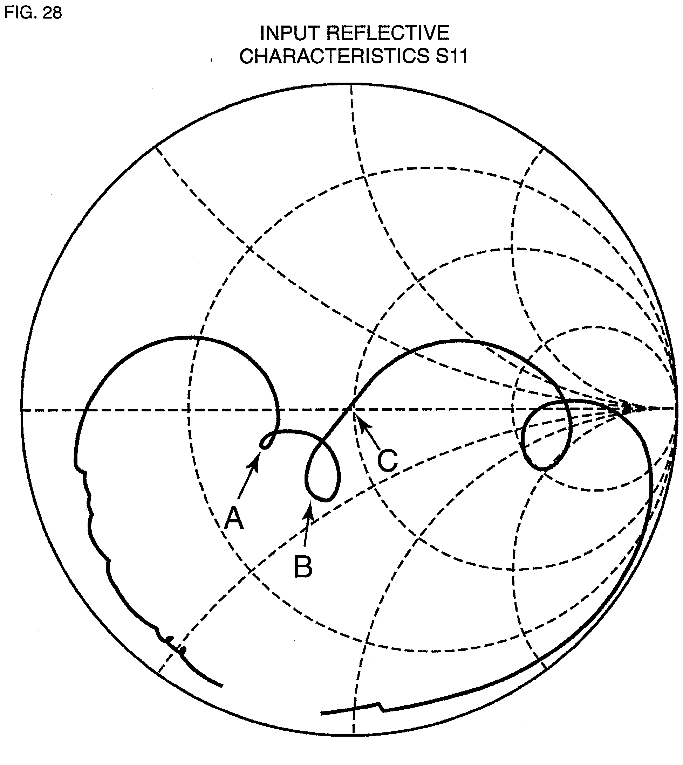

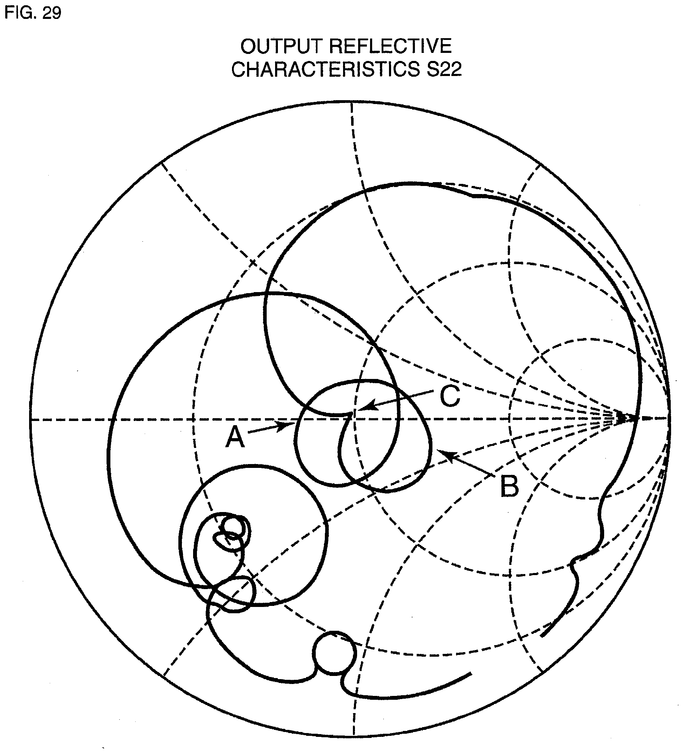

FIG. 28 plots, in a Smith chart, reflective characteristics S11 at the input of the surface acoustic wave filter 1000, and FIG. 29 plots, in a Smith chart, reflective characteristics S22 at the output of the surface acoustic wave filter 1000. As understood from FIGS. 28 and 29, the resonance mode C is placed closer to the impedance matching point than in the first embodiment. The second embodiment presents better VSWR characteristics than the first embodiment. With an increased number of serially connected surface acoustic wave resonators in addition to those in the first embodiment, the second embodiment suffers from a slight degradation in insertion loss within the passband. The second embodiment is therefore more advantageous than the first embodiment in a filter application in which the VSWR characteristic is more important than the insertion loss within the passband.

The longitudinally coupled resonator type surface acoustic wave filter 1000 of the second embodiment includes the surface acoustic wave resonators 1023 and 1024 respectively serially connected to the inputs of the longitudinally coupled resonator type surface acoustic filter sections, namely, the terminals to which a smaller number of IDTs is connected. The resonance frequency of the surface acoustic wave resonators falls within the passband of the longitudinally coupled resonator type surface acoustic wave filter sections 1001 and 1002, and the antiresonance frequency of the surface acoustic wave resonator falls out of the passband in the vicinity of the high frequency region of the passband. The use of the surface acoustic wave resonators 1021 through 1024 places the impedance of the resonance mode C in the high frequency region of the surface acoustic wave filter 1000 closer to the impedance matching point. The second embodiment thus presents better VSWR than the first embodiment.

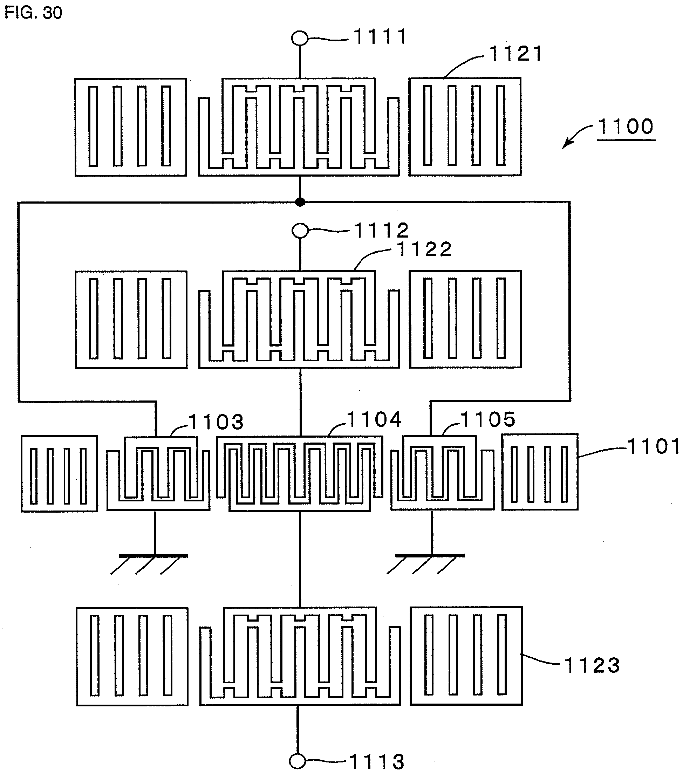

FIGS. 30 through 35 are circuit diagrams showing modifications of the surface acoustic wave filter 1000 of the second embodiment.

A surface acoustic wave filter 1100 shown in FIG. 30 is a modification of the surface acoustic wave filter 1000 having an unbalance-balance converting function. A longitudinally coupled resonator type surface acoustic wave filter section 1101 includes three IDTs 1103 through 1105. A surface acoustic wave resonator 1121 is serially connected to each of the IDTs 1103 and 1105, and is also connected to an unbalanced signal terminal 1111. A pair of balanced signal terminals 1112 and 1113 are respectively connected to both ends of the center IDT 1104 through surface acoustic wave resonators 1122 and 1123.

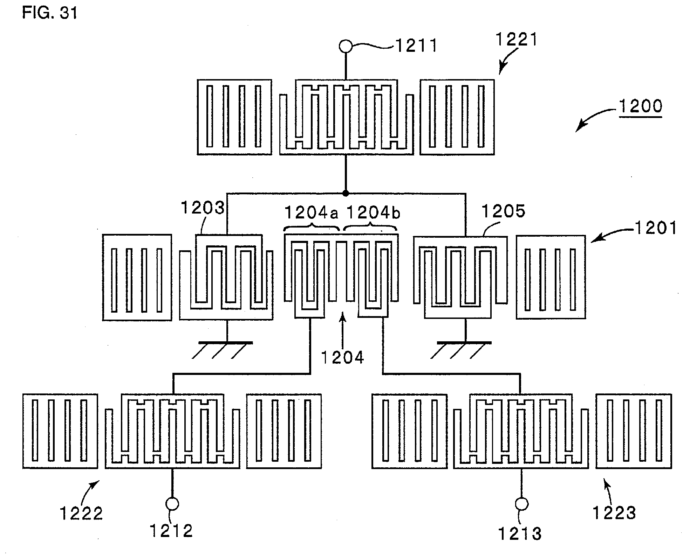

A surface acoustic wave filter 1200 shown in FIG. 31 uses a longitudinally coupled resonator type surface acoustic filter wave section 1201 having three IDTs. The center IDT 1204 from among the IDTs 1203 through 1205 has two separate IDT sections 1204a and 1204b arranged in the direction of propagation of the surface acoustic wave. An unbalanced signal terminal 1211 is connected to each of the IDTs 1203 and 1205 through a surface acoustic wave resonator 1221. A pair of balanced signal terminals 1212 and 1213 are respectively connected to the IDT sections 1204a and 1204b of the IDT 1204 through surface acoustic wave resonators 1222 and 1223.

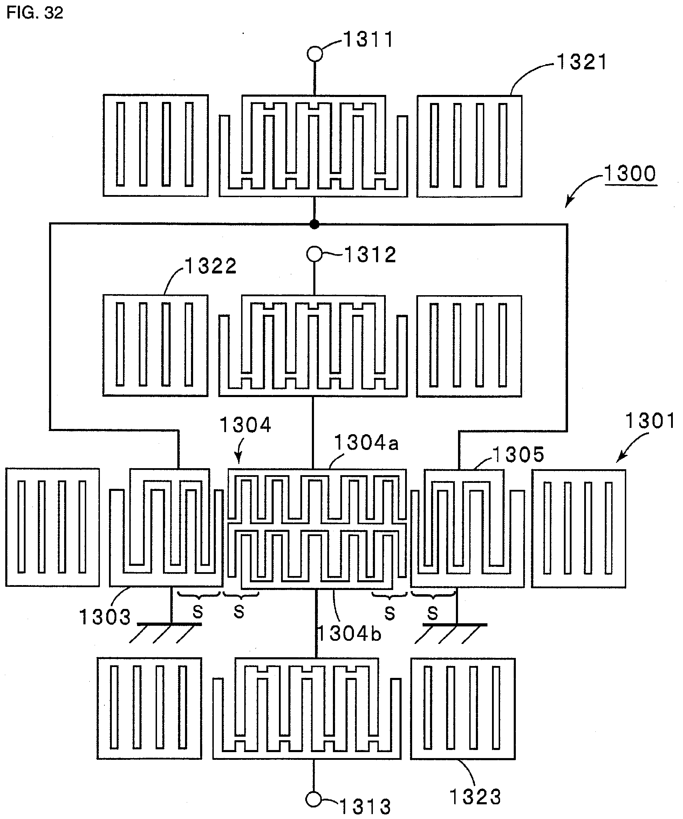

Unlike the surface acoustic wave filter 1200 shown in FIG. 31, a surface acoustic wave filter 1300 shown in FIG. 32 has a longitudinally coupled resonator type surface acoustic wave filter section 1301 which includes a center IDT 1304 that is split into two IDTs 1304a and 1304b along a line transversely extending across the electrode fingers. A pair of balanced signal terminals 1312 and 1313 are respectively connected to the IDT sections 1304a and 1304b through surface acoustic wave resonators 1322 and 1323. Outside IDTs 1303 and 1305, which are commonly connected, are connected to an unbalanced signal terminal 1311 through a surface acoustic wave resonator 1321.

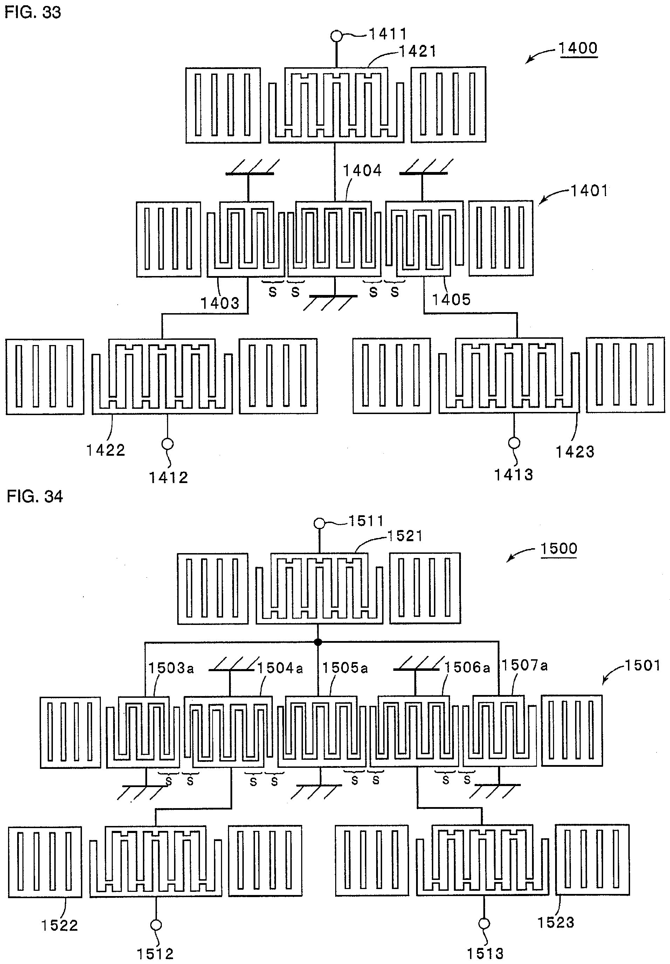

In a surface acoustic wave filter 1400 shown in FIG. 33, an unbalanced signal terminal 1411 is connected to a center IDT 1404 of a longitudinally coupled resonator type surface acoustic wave filter section 1401. IDTs 1403 and 1405 on both sides of the center IDT 1404 are respectively connected to balanced signal terminals 1412 and 1413 through surface acoustic wave resonators 1422 and 1423. The IDT 1403 and IDT 1405 are configured to be opposite in polarity from each other.

The surface acoustic wave filter 1400 shown in FIG. 33 has the three IDTs 1403 through 1405. In an alternative arrangement, a surface acoustic wave filter 1500 of a modification of the second embodiment, shown in FIG. 34, employs a longitudinally coupled resonator type surface acoustic wave filter section 1501 including five IDTs 1503a-1507a.

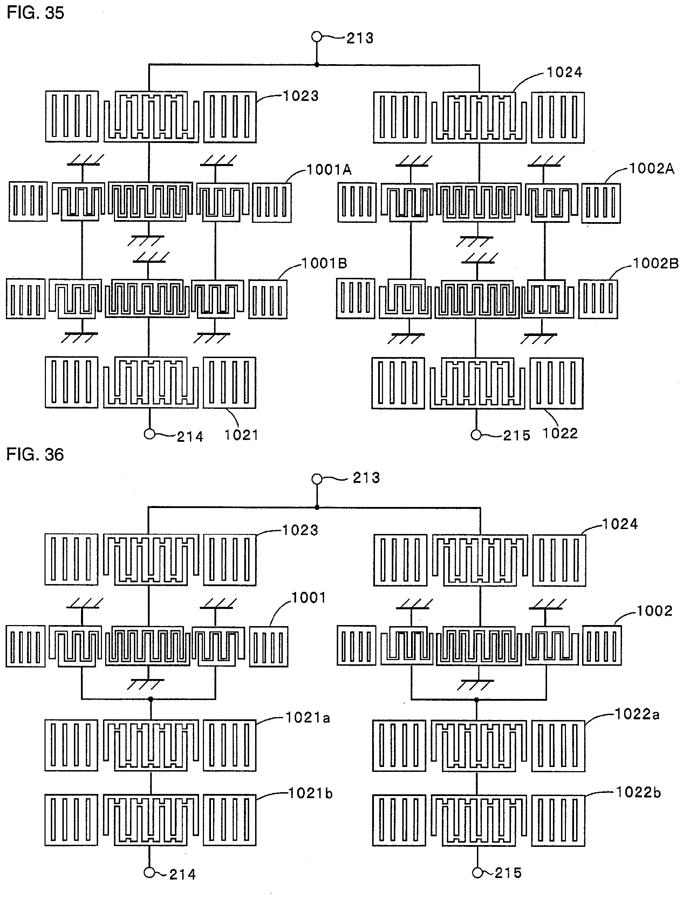

A modification of the surface acoustic wave filter 1000 shown in FIG. 35 includes a longitudinally coupled resonator type surface acoustic wave filter section 1001 including a serial connection of a longitudinally coupled resonator type surface acoustic wave filter section 1001A and a longitudinally coupled resonator type surface acoustic wave filter section 1001B, and a longitudinally coupled resonator type surface acoustic wave filter section 1002 including a serial connection of a longitudinally coupled resonator type surface acoustic wave filter section 1002A and a longitudinally coupled resonator type surface acoustic wave filter section 1002B.

In the above embodiments, a single surface acoustic wave resonator is connected to each of the input and output of the surface acoustic wave filter section. Alternatively, a plurality of surface acoustic wave resonators may be connected to each of the input and output of the surface acoustic wave filter section.

Referring to FIG. 36, two surface acoustic wave resonators 1021a and 1021b may be connected to the output of the surface acoustic wave filter section 1001, and two surface acoustic wave resonators 1022a and 1022b may be connected to the output of the surface acoustic wave filter section 1002.

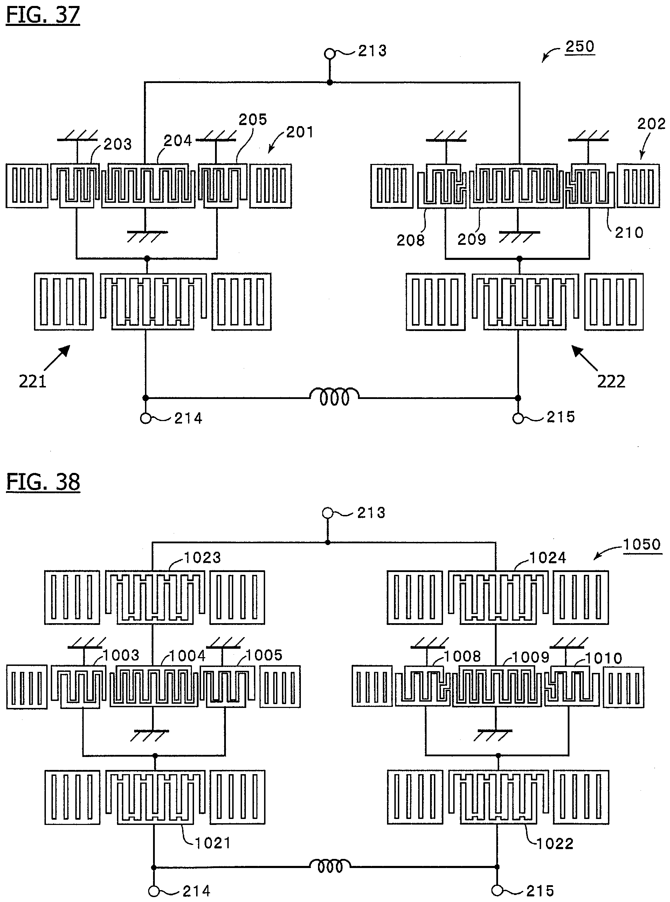

FIG. 37 is a plan view diagrammatically showing the electrode structure of the surface acoustic wave filter 250 of a third embodiment of the present invention. Electrode fingers are serially weighted in each of IDTs 208 and 210 in a longitudinally coupled resonator type surface acoustic wave filter 202. Specifically, each IDT has several serially weighted electrode fingers in the area thereof that is adjacent to another IDT. The rest of the surface acoustic wave filter 250 remains identical to the surface acoustic wave filter 200 of the first embodiment.

Weighting of the electrode fingers improves amplitude difference and phase difference, each of which is important in the surface acoustic wave filter having the unbalance-balance converting function. Specifically, the weighting may be incorporated to compensate for a deviation in the amplitude characteristic and a deviation in a phase difference of 180° of the longitudinally coupled resonator type surface acoustic wave filter sections 201 and 202.

If the weighting is introduced in the adjacent portion of each IDT, the resonance mode C shown in FIG. 7 becomes high impedance. The VSWR in the passband may be degraded. However, since the propagation path of the surface acoustic wave is not made discontinuous, the quality factor Q itself of the resonance mode is not degraded. In the third embodiment, the VSWR is improved as in the first embodiment by placing the impedance at the resonance mode C close to the impedance matching point using the surface acoustic wave resonators 221 and 222.

FIG. 38 shows a surface acoustic wave filter 1050 which is produced by serially weighting the surface acoustic wave filter 1000 of the second embodiment. The surface acoustic wave filter 1050 places the impedance at the resonance mode C close to the impedance matching point using surface acoustic wave resonators 1021 through 1024, thereby improving the VSWR in the same way as in the second embodiment.

Referring to FIGS. 37 and 38, electrode fingers are serially weighted in the areas of the IDTs 208 and 210 that are adjacent to other IDTs, and electrode fingers are serially weighted in the comparable areas of the IDTs 1008 and 1010. Other weighing methods may be used. For example, the electrode fingers may be weighted by decimating the fingers, by varying the transverse width of the electrode fingers, or by varying the duty factor of the electrode fingers.

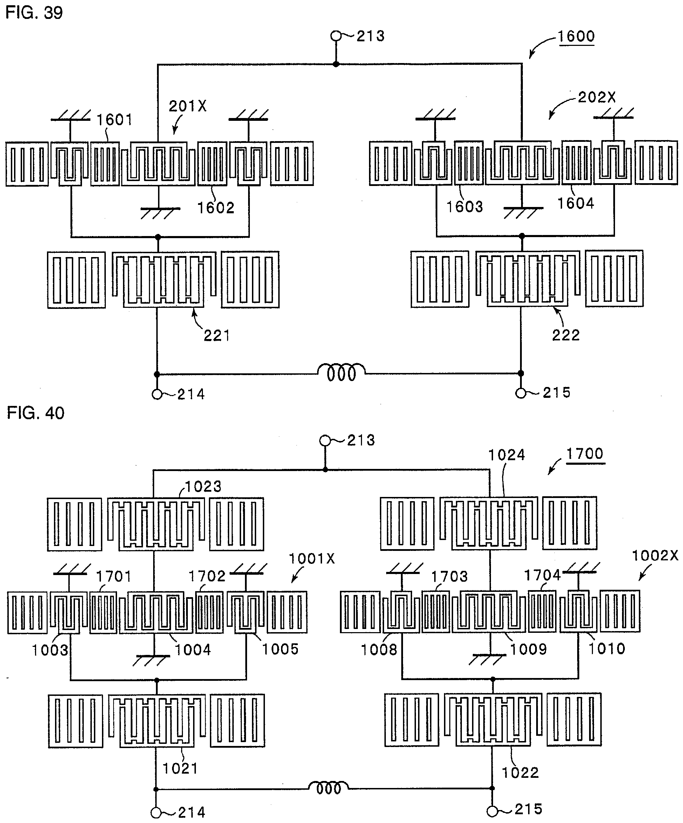

FIG. 39 is a plan view diagrammatically showing the electrode structure of the surface acoustic wave filter 1600 in accordance with a fourth embodiment of the present invention. In the surface acoustic wave filter 1600 of the fourth embodiment, longitudinally coupled resonator type surface acoustic wave filter sections 201X and 202X have no narrow-pitched electrode finger portions. Instead, reflectors 1601 through 1604, each having almost the same electrode finger pitch as the narrow-pitched electrode portion, are provided. The rest of the fourth embodiment remains unchanged from the surface acoustic wave filter 200 of the first embodiment.

Since each of the reflectors 1601 through 1604 is placed in the longitudinally coupled resonator type surface acoustic wave filter sections 201X and 202X in an area where IDTs are adjacent to each other, the impedance at the resonance mode C may become high, and the VSWR within the passband may be degraded. However, since the propagation path of the surface acoustic wave is not made discontinuous in the fourth embodiment, the quality factor Q itself of the resonance mode is not degraded. As in the first embodiment, the VSWR is improved by placing the impedance at the resonance mode C close to the impedance matching point using the surface acoustic wave resonators 221 and 222.

FIG. 40 is a plan view diagrammatically showing a surface acoustic wave filter 1700. The surface acoustic wave filter 1700 is produced by removing the narrow-pitched electrode finger portion from the surface acoustic wave filter 1000 of the second embodiment, and by providing instead reflectors 1701 through 1704, each having an electrode finger pitch substantially equal to the electrode finger pitch of the narrow-pitched electrode finger portion. In the surface acoustic wave filter 1700, the use of surface acoustic wave resonators 1021 through 1024 places the impedance at the resonance mode C close to the impedance matching point, thereby improving the VSWR in the same way as in the second embodiment.

In the surface acoustic wave filters according to certain preferred embodiments of the present invention, at least one surface acoustic wave resonator is serially connected between one of the input terminal and output terminal and a longitudinally-coupled resonator-type, threefold mode surface acoustic filter section including at least two IDTs each having a narrow-pitched electrode finger portion. The impedance of the surface acoustic surface acoustic wave filter section at the resonance mode in the highest frequency region is capacitive. The resonance point of the surface acoustic wave resonator falls within the passband of the filter, and the antiresonance point is placed in the vicinity of the highest frequency region of the passband. The impedance of the surface acoustic wave filter section at the resonance mode in the highest frequency region is close to the impedance matching point. With the impedance at the resonance mode in the highest frequency region set to be capacitive, impedance matching is performed using the added surface acoustic wave resonator. In other words, the resonance mode in the capacitive impedance is set to be close to inductive impedance, by substantially coinciding the frequency band of the resonance mode in the high frequency region working in a capacitive impedance with the frequency band working in an inductive impedance of a trap circuit (the frequency band between the resonance point and the antiresonance point). Specifically, since the resonance mode in the highest frequency region is set be close to inductive impedance, there is no need for narrowing the frequency separation between the three resonance modes. A wide band feature is thus easily implemented. Since the surface acoustic wave filter section having the narrow-pitched electrode finger portion is used, the insertion loss within the passband is reduced. Even with the wide band feature implemented, the VSWR characteristic is improved without degrading the transmission characteristic in the passband.

In other preferred embodiments of surface acoustic wave filter, at least one surface acoustic wave resonator is serially connected between one of the input terminal and output terminal and a longitudinally-coupled resonator-type, threefold mode surface acoustic filter section including a reflector, arranged between adjacent IDTs, the reflector(s) having a plurality of electrode fingers at a electrode finger pitch narrower than each IDT.

The impedance of the surface acoustic wave filter section at the resonance mode, out of the three resonance modes, in the highest frequency region becomes capacitive. The resonance point of the surface acoustic wave resonator falls within the passband of the filter, and the antiresonance point is placed out of the highest frequency region of the passband. The impedance of the surface acoustic wave filter section at the resonance mode in the highest frequency region is close to the impedance matching point. With the impedance at the resonance mode in the highest frequency region set to be capacitive, impedance matching is performed using the added surface acoustic wave resonator. In other words, the resonance mode in the capacitive impedance is set to be close to inductive impedance by substantially coinciding the frequency bandwidth at the resonance mode in the highest frequency region with the frequency band of the trap circuit in the inductive impedance. Since the surface acoustic wave filter section having the narrow-pitched electrode finger portion is used, the insertion loss within the passband is reduced. Even with the wide band feature implemented, the VSWR characteristic is improved without degrading the transmission characteristic in the passband.

The present invention also provides a communications apparatus making use of one of more surface acoustic wave filter devices according to any of the various above-described embodiments of the invention.

Although the present invention has been described in terms of certain illustrative examples of embodiments thereof, it is to be understood that modifications and variations can be made in the details of the specific embodiments without departing from the present invention as defined in the accompanying claims.

## Claims

1. A surface acoustic wave filter (200) comprising:
a surface acoustic wave filter section (201/202) comprising a piezoelectric substrate (X), at least three interdigital transducers (203-205/208-210) arranged in a direction of propagation of a surface acoustic wave on the piezoelectric substrate; and
at least one surface acoustic wave resonator (221/222) connected in series between the surface acoustic wave filter section (201/202) and one of an input signal terminal (213/214,215) and an output signal terminal (214, 215/213) of the surface acoustic wave filter, wherein the surface acoustic wave filter section (201/202) is a threefold mode surface acoustic wave filter section of a longitudinally coupled resonator type, and the impedance of the surface acoustic wave filter section is capacitive in the highest-frequency resonance mode out of the three resonance modes,
wherein the resonance frequency of the surface acoustic wave resonator (221/222) is positioned within the passband of the surface acoustic wave filter section (201/202), and the antiresonance frequency of the surface acoustic wave resonator is positioned outside of the passband of the surface acoustic wave filter section and in the vicinity of the high frequency region of the passband of the surface acoustic wave filter section, and
wherein the surface acoustic wave resonator (221/222) is formed so that the frequency band between said resonance frequency and said antiresonance frequency substantially coincides with the frequency band of said highest-frequency resonance mode.

2. A surface acoustic wave filter according to claim 1, wherein each of the interdigital transducers (203-205/208-210) has, at the end or ends thereof that are adjacent to other interdigital transducers, a narrow-pitched electrode finger portion (s) in which a pitch of electrode fingers is narrower than that of electrode fingers in the remaining portion of the interdigital transducer.

3. A surface acoustic wave filter (250/1050) according to claim 1 or 2, wherein at least a portion of one or more of the interdigital transducers (208,210/1008,1010) is weighted in an area where a plurality of interdigital transducers are adjacent to each other in the surface acoustic filter section.

4. A surface acoustic wave filter (1600/1700) according to claim 1, and further comprising a reflector (1601-4/1701-4), arranged between adjacent interdigital transducers, the reflector(s) having a plurality of electrode fingers at an electrode finger pitch different from the finger pitch of the interdigital transducers.

5. A surface acoustic wave filter according to any one of claims 1 to 4, wherein the surface acoustic filter section (201/202) includes an odd number of interdigital transducers (203-5/208-210), and wherein at least one surface acoustic wave resonator (221/222) is connected between the surface acoustic wave filter section and one of the input signal terminal (213/214,215) and the output signal terminal (214,215/213) whichever has a larger number of interdigital transducers connected thereto.

6. A surface acoustic wave filter (1000) according to any one of claims 1 to 4, wherein the at least one surface acoustic wave resonators include at least one surface acoustic wave resonator (1023,1024/1021,1022) connected in series between the surface acoustic wave filter section and the input signal terminal (213/214,215), and at least one surface acoustic wave resonator (1021,1022/1023,1024) connected in series between the surface acoustic wave filter section and the output signal terminal (214,215/213.

7. A surface acoustic wave filter according to any previous claim, comprising a plurality of surface acoustic wave resonators (1021a,b/1022a,b) connected between the surface acoustic wave filter section and at least one of the input signal terminal and the output signal terminal.

8. A surface acoustic wave filter according to any previous claim, wherein at least one of the input signal terminal and the output signal terminal comprises a pair of balanced signal terminals (214,215).

9. A surface acoustic wave filter according to any previous claim, wherein the surface acoustic wave filter is configured to function as an unbalance-balance converter with one of the input signal terminal and the output signal terminal being a balanced signal terminal, and the other of the input signal terminal and the output signal terminal being an unbalanced signal terminal.

10. A surface acoustic wave filter according to claim 9, wherein an other surface acoustic wave filter section (202) is provided, an output signal of the surface acoustic wave filter section (201) being different in phase by 180° from an output signal of the other surface acoustic wave filter section (202), first terminals of the surface acoustic wave filter section (201) and of the other surface acoustic filter section (202) being connected together, to form the unbalanced signal terminal (213), and second terminals of the surface acoustic wave filter section (201) and of the other surface acoustic filter section (202) forming the balanced signal terminals (214,215).

11. A surface acoustic wave filter (500) according to claim 9, wherein terminals of the surface acoustic wave filter section form a pair of balanced signal terminals (512,513), and the other terminal of the surface acoustic wave filter section forms the unbalanced signal terminal (511).

12. A surface acoustic wave filter (600/700) according to claim 10, wherein at least one interdigital transducer of the surface acoustic wave filter section is split into first and second separate interdigital transducer sections (604a,b/704a,b) split in a direction across the electrode finger or in a direction of propagation of a surface acoustic wave.

13. A surface acoustic wave filter according to any previous claim, wherein the surface acoustic wave resonator and the surface acoustic wave filter section are formed on the same piezoelectric substrate (X).

14. A surface acoustic wave filter according to any previous claim, further comprising a case plate (251), wherein the piezoelectric substrate (X) is mounted on the case plate (251) in a manner such that the side of the piezoelectric substrate bearing the surface acoustic wave filter section and the surface acoustic wave resonator faces the case plate.

15. A communications apparatus comprising a surface acoustic wave filter according to any of claims 1 to 14.

## Patentansprüche

1. Akustisches Oberflächenwellenfilter (200), umfassend:
einen akustischen Oberflächenwellenfilterteil (201/202), umfassend ein piezoelektrisches Substrat (X), mindestens drei Interdigitalwandler (203-205/208-210), die in einer Ausbreitungsrichtung einer akustischen Oberflächenwelle auf dem piezoelektrischen Substrat angeordnet sind, und
mindestens einen akustischen Oberflächenwellenresonator (221/222), der zwischen dem akustischen Oberflächenwellenfilterteil (201/202) und einem von einem Eingangssignalanschluss (213/214,215) und einem Ausgangssignalanschluss (214,215/213) des akustischen Oberflächenwellenfilters in Reihe geschaltet ist, wobei der akustische Oberflächenwellenfilterteil (201/202) ein akustischer Oberflächenwellenfilterteil mit dreifachem Modus von einem longitudinal gekoppelten Resonatortyp ist und die Impedanz des akustischen Oberflächenwellenfilterteils in dem höchstfrequenten Resonanzmodus unter den drei Resonanzmodi kapazitiv ist, wobei die Resonanzfrequenz des akustischen Oberflächenwellenresonators (221/222) innerhalb der Passbandes des akustischen Oberflächenwellenfilterteils (201/202) angeordnet ist und die Antiresonanzfrequenz des akustischen Oberflächenwellenresonators außerhalb des Passbandes des akustischen Oberflächenwellenfilterteils und in der Nähe des Hochfrequenzbereichs des Passbandes des akustischen Oberflächenwellenfilterteils angeordnet ist, und
wobei der akustische Oberflächenwellenresonator (221/222) so ausgebildet ist, dass sich das Frequenzband zwischen der Resonanzfrequenz und der Antiresonanzfrequenz im Wesentlichen mit dem Frequenzband des Resonanzmodus der höchsten Frequenz deckt.

2. Akustisches Oberflächenwellenfilter nach Anspruch 1, wobei jeder der Interdigitalwandler (203-205/208-210) an dem Ende oder den Enden davon, die benachbart zu anderen Interdigitalwandlern sind, einen Elektrodenfingerteil mit schmalem Abstand aufweist, bei dem ein Abstand der Elektrodenfinger schmaler ist, als der von den Elektrodenfingern in dem verbleibenden Teil von dem Interdigitalwandler.

3. Akustisches Oberflächenwellenfilter (250/1050) nach Anspruch 1 oder 2, wobei mindestens ein Teil von einem oder mehreren Interdigitalwandlern (208,210/1008,1010) in einem Bereich in dem Oberflächenwellenfilterteil gewichtet ist, wo mehrere Interdigitalwandler zueinander benachbart sind.

4. Akustisches Oberflächenwellenfilter (1600/1700) nach Anspruch 1, und ferner umfassend einen Reflektor (1601-4/1701-4), der zwischen benachbarten Interdigitalwandlern angeordnet ist, wobei der/die Reflektor/-en mehrere Elektrodenfinger mit einem gegenseitigen Elektrodenfingerabstand, der sich von dem Fingerabstand der Interdigitalwandler unterscheidet, umfasst/umfassen.

5. Akustisches Oberflächenwellenfilter nach einem der Ansprüche 1 bis 4, wobei der akustische Oberflächenwellenfilterteil (201/202) eine ungerade Anzahl von Interdigitalwandlern (203-5/208-210) beinhaltet, und wobei mindestens ein akustischer Oberflächenwellenresonator (221/222) zwischen dem akustischen Oberflächenwellenfilterteil und einem von dem Eingangssignalanschluss (213/214,215) und dem Ausgangssignalanschluss (214,215/213), je nachdem, welcher eine größere Anzahl von damit verbundenen Interdigitalwandlern aufweist, verbunden ist.

6. Akustisches Oberflächenwellenfilter (1000) nach einem der Ansprüche 1 bis 4, wobei die mindestens einen akustischen Oberflächenwellenresonatoren mindestens einen akustischen Oberflächenwellenresonator (1023,1024/1021,1022), der zwischen dem akustischen Oberflächenwellenfilterteil und dem Eingangssignalanschluss (213/214,215) in Reihe geschaltet ist, und mindestens einen akustischen Oberflächenwellenresonator (1021,1022/1023,1024), der zwischen dem akustischen Oberflächenwellenfilterteil und dem Ausgangssignalanschluss (214,215/213) in Reihe geschaltet ist, beinhalten.

7. Akustisches Oberflächenwellenfilter nach einem der vorhergehenden Ansprüche, umfassend mehrere akustische Oberflächenwellenresonatoren (1021a,b/1022a,b), die zwischen dem akustischen Oberflächenwellenfilterteil und mindestens einem von dem Eingangssignalanschluss und dem Ausgangssignalanschluss verbunden sind.

8. Akustisches Oberflächenwellenfilter nach einem der vorhergehenden Ansprüche, wobei mindestens einer von dem Eingangssignalanschluss und dem Ausgangssignalanschluss ein Paar symmetrische Signalanschlüsse (214,215) umfasst.

9. Akustisches Oberflächenwellenfilter nach einem der vorhergehenden Ansprüche, wobei das akustische Oberflächenwellenfilter konfiguriert ist, als ein Asymmetrie-Symmetrie-Wandler zu fungieren, wobei einer von dem Eingangssignalanschluss und dem Ausgangssignalanschluss ein symmetrischer Signalanschluss ist und der andere von dem Eingangssignalanschluss und dem Ausgangssignalanschluss ein asymmetrischer Signalanschluss ist.

10. Akustisches Oberflächenwellenfilter nach Anspruch 9, wobei ein anderer akustischer Oberflächenwellenfilterteil (202) bereitgestellt ist, sich ein Ausgangssignal des akustischen Oberflächenwellenfilterteils (201) in der Phase um 180° von einem Ausgangssignal des anderen Oberflächenwellenfilterteils (202) unterscheidet, erste Anschlüsse des akustischen Oberflächenwellenfilterteils (201) und des anderen akustischen Oberflächenwellenfilterteils (202) miteinander verbunden sind, um den asymmetrischen Signalanschluss (213) zu bilden, und wobei zweite Anschlüsse von dem akustischen Oberflächenwellenfilterteil (201) und von dem anderen akustischen Oberflächenwellenfilterteil (202) die symmetrischen Signalanschlüsse (214,215) bilden.

11. Akustisches Oberflächenwellenfilter (500) nach Anspruch 9, wobei Anschlüsse des akustischen Oberflächenwellenfilterteils ein Paar symmetrische Signalanschlüsse (512,513) bilden und der andere Anschluss des akustischen Oberflächenwellenfilterteils den asymmetrischen Signalanschluss (511) bildet.

12. Akustisches Oberflächenwellenfilter (600/700) nach Anspruch 10, wobei mindestens ein Interdigitalwandler des akustischen Oberflächenwellenfilterteils in erste und zweite separate Interdigitalwandlerteile (604a,b/704a,b) aufgeteilt ist, die in einer Richtung über den Elektrodenfinger hinweg oder in einer Ausbreitungsrichtung einer akustischen Oberflächenwelle aufgeteilt sind.

13. Akustisches Oberflächenwellenfilter nach einem der vorhergehenden Ansprüche, wobei der akustische Oberflächenwellenresonator und der akustische Oberflächenwellenfilterteil auf demselben piezoelektrischen Substrat (X) ausgebildet sind.

14. Akustisches Oberflächenwellenfilter nach einem der vorhergehenden Ansprüche, ferner umfassend eine Gehäuseplatte (251), wobei das piezoelektrische Substrat (X) auf der Gehäuseplatte (251) in einer Weise befestigt ist, dass die Seite des piezoelektrischen Substrats, die den akustischen Oberflächenwellenfilterteil und den akustischen Oberflächenwellenresonator trägt, der Gehäuseplatte zugewandt ist.

15. Kommunikationsvorrichtung, umfassend ein akustisches Oberflächenwellenfilter nach einem der Ansprüche 1 bis 14.

## Revendications

1. Filtre à ondes acoustiques de surface (200) comprenant :
une section filtre à ondes acoustiques de surface (201/202) comprenant un substrat piézoélectrique (X), au moins trois transducteurs interdigités (203 à 205 / 208 à 210) disposés dans une direction de propagation d'une onde acoustique de surface sur le substrat piézoélectrique ; et
au moins un résonateur à ondes acoustiques de surface (221/222) connecté en série entre la section filtre à ondes acoustiques de surface (201/202) et soit une borne d'entrée de signal (213 / 214, 215) soit une borne de sortie de signal (214, 215 / 213) du filtre à ondes acoustiques de surface, dans lequel la section filtre à ondes acoustiques de surface (201/202) est une section filtre à ondes acoustiques de surface à trois modes de type à résonateurs à couplage longitudinal, et l'impédance de la section filtre à ondes acoustiques de surface est capacitive dans le mode de résonance à fréquence la plus haute parmi les trois modes de résonance,
dans lequel la fréquence de résonance du résonateur à ondes acoustiques de surface (221/222) est positionnée à l'intérieur de la bande passante de la section filtre à ondes acoustiques de surface (201/202), et la fréquence d'antirésonance du résonateur à ondes acoustiques de surface est positionnée à l'extérieur de la bande passante de la section filtre à ondes acoustiques de surface et au voisinage de la région à haute fréquence de la bande passante de la section filtre à ondes acoustiques de surface, et
dans lequel le résonateur à ondes acoustiques de surface (221/222) est formé de manière que la bande de fréquences entre ladite fréquence de résonance et ladite fréquence d'antirésonance coïncide sensiblement avec la bande de fréquences dudit mode de résonance à fréquence la plus haute.

2. Filtre à ondes acoustiques de surface selon la revendication 1, dans lequel chacun des transducteurs interdigités (203 à 205 / 208 à 210) comporte, à son ou ses extrémité(s) qui est ou sont adjacente(s) à d'autres transducteurs interdigités, une ou des partie(s) à doigt(s) d'électrode(s) à pas étroit, dans laquelle ou lesquelles un pas des doigts d'électrodes est plus étroit que celui de doigts d'électrodes dans la partie restante du transducteur interdigité.

3. Filtre à ondes acoustiques de surface (250/1050) selon la revendication 1 ou 2, dans lequel au moins une partie d'un ou de plusieurs des transducteurs interdigités (208, 210 / 1008, 1010) est pondérée dans une zone où plusieurs transducteurs interdigités sont adjacents les uns aux autres dans la section filtre acoustique de surface.

4. Filtre à ondes acoustiques de surface (1600/1700) selon la revendication 1, et comprenant en outre un réflecteur (1601 à 1604 / 1701 à 1704), disposé entre des transducteurs interdigités adjacents, le(s) réflecteur(s) comportant une pluralité de doigts d'électrodes à un pas de doigts d'électrodes différent du pas de doigts des transducteurs interdigités.

5. Filtre à ondes acoustiques de surface selon l'une quelconque des revendications 1 à 4, dans lequel la section filtre acoustique de surface (201/202) comporte un nombre impair de transducteurs interdigités (203 à 205 / 208 à 210), et dans lequel au moins un résonateur à ondes acoustiques de surface (221/222) est connecté entre la section filtre à ondes acoustiques de surface et soit la borne d'entrée de signal (213 / 214, 215) soit la borne de sortie de signal (214, 215 / 213), celle à laquelle le plus grand nombre de transducteurs interdigités est connecté étant retenue.

6. Filtre à ondes acoustiques de surface (1000) selon l'une quelconque des revendications 1 à 4, dans lequel le au moins un résonateur à ondes acoustiques de surface inclut au moins un résonateur à ondes acoustiques de surface (1023, 1024 / 1021, 1022) connecté en série entre la section filtre à ondes acoustiques de surface et la borne d'entrée de signal (213 / 214, 215), et au moins un résonateur à ondes acoustiques de surface (1021, 1022 / 1023, 1024) connecté en série entre la section filtre à ondes acoustiques de surface et la borne de sortie de signal (214, 215 / 213).

7. Filtre à ondes acoustiques de surface selon l'une quelconque des revendications précédentes, comprenant une pluralité de résonateurs à ondes acoustiques de surface (1021a, b/1022a, b) connectés entre la section filtre à ondes acoustiques de surface et au moins une borne parmi la borne d'entrée de signal et la borne de sortie de signal.

8. Filtre à ondes acoustiques de surface selon l'une quelconque des revendications précédentes, dans lequel au moins une borne parmi la borne d'entrée de signal et la borne de sortie de signal comprend une paire de bornes de signaux équilibrées (214, 215).

9. Filtre à ondes acoustiques de surface selon l'une quelconque des revendications précédentes, dans lequel le filtre à ondes acoustiques de surface est conçu pour fonctionner comme un convertisseur de déséquilibre-équilibre, l'une de la borne d'entrée de signal et de la borne de sortie de signal étant une borne de signal équilibrée, et l'autre de la borne d'entrée de signal et de la borne de sortie de signal étant une borne de signal déséquilibrée.

10. Filtre à ondes acoustiques de surface selon la revendication 9, dans lequel une autre section filtre à ondes acoustiques de surface (202) est mise en place, un signal de sortie de la section filtre à ondes acoustiques de surface (201) présentant une différence de phase de 180° par rapport à un signal de sortie de l'autre section filtre à ondes acoustiques de surface (202), les premières bornes de la section filtre à ondes acoustiques de surface (201) et de l'autre section filtre acoustique de surface (202) étant connectées entre elles, pour former une borne de signal déséquilibrée (213), et les secondes bornes de la section filtre à ondes acoustiques de surface (201) et de l'autre section filtre acoustique de surface (202) formant les bornes de signaux équilibrées (214, 215).

11. Filtre à ondes acoustiques de surface (500) selon la revendication 9, dans lequel des bornes de la section filtre à ondes acoustiques de surface forment une paire de bornes de signaux équilibrées (512, 513), et l'autre borne de la section filtre à ondes acoustiques de surface forme la borne de signal déséquilibrée (511).

12. Filtre à ondes acoustiques de surface (600/700) selon la revendication 10, dans lequel au moins un transducteur interdigité de la section filtre à ondes acoustiques de surface est divisé en première et seconde sections séparées de transducteur interdigité (604a, b/704a, b), divisées dans une direction transversale au doigt d'électrode ou dans une direction de propagation d'une onde acoustique de surface.

13. Filtre à ondes acoustiques de surface selon l'une quelconque des revendications précédentes, dans lequel le résonateur à ondes acoustiques de surface et la section filtre à ondes acoustiques de surface sont formés sur le même substrat piézoélectrique (X).

14. Filtre à ondes acoustiques de surface selon l'une quelconque des revendications précédentes, comprenant en outre une plaque de boîtier (251), dans lequel le substrat piézoélectrique (X) est monté sur la plaque de boîtier (251), de manière que le côté du substrat piézoélectrique supportant la section filtre à ondes acoustiques de surface et le résonateur à ondes acoustiques de surface soit en regard de la plaque de boîtier.

15. Appareil de communication comprenant un filtre à ondes acoustiques de surface selon l'une quelconque des revendications 1 à 14.
